# EUROPÄISCHE PATENTSCHRIFT

(11) **EP 1 909 111 B1**
(45) Veröffentlichungstag und Bekanntmachung des Hinweises auf die Patenterteilung: **24.04.2013**
(21) Anmeldenummer: 07019260.4
(22) Anmeldetag: 01.10.2007
(51) Int. Cl.: G01R 33/31

(54) **Vakuumbehälter für gekühlten Magnet-Resonanz-Probenkopf**
Vacuum container for a cooled magnetic resonance sensor head
Récipient sous vide pour tête d'échantillon à résonance magnétique refroidie

(30) Priorität: 04.10.2006 DE 102006046888
(43) Veröffentlichungstag der Anmeldung: 09.04.2008
(73) Patentinhaber: Bruker BioSpin AG, 8117 Fällanden (CH)
(72) Erfinder: Freytag, Nicolas, 8122 Binz (CH)
(74) Vertreter: Kohler Schmid Möbus

(56) Entgegenhaltungen:
- EP-A- 0 461 493
- EP-A- 1 251 361
- DE-A1- 1 912 604
- US-A- 5 585 723
- US-A1- 2003 206 020
- US-A1- 2004 004 478
- US-A1- 2004 108 852

## Beschreibung

Die Erfindung betrifft einen Magnetresonanz-Probenkopf, umfassend einen Vakuumbehälter, in welchem mehrere, kryogen kühlbare HF-Resonatorspulen angeordnet sind, wobei die Gesamtheit der HF-Resonatorspulen eine größere Erstreckung in einer x-Richtung als in einer y-Richtung aufweist, wobei die Gesamtheit der HF-Resonatorspulen spiegelsymmetrisch bezüglich einer xz-Ebene angeordnet ist, und wobei die Richtungen x, y, z ein rechtwinkliges Koordinatensystem bilden.

Ein solcher Magnetresonanz-Probenkopf ist beispielsweise bekannt geworden durch US 2004/0108852 A1, das auch als nächstliegender Stand der Technik angesehen wird.

Zur Analyse von Probenzusammensetzungen oder zur Strukturbestimmung von Stoffen in Proben werden Kernspinresonanz(=NMR)-Verfahren eingesetzt. Bei diesen NMR-Verfahren ist die Probe einem starken statischen Magnetfeld B₀ in einer z-Richtung ausgesetzt, und es werden dazu orthogonale hochfrequente elektromagnetische Impulse in x- oder y-Richtung in die Probe eingestrahlt. Dabei kommt es zu einer Wechselwirkung mit den Kernspins des Probenmaterials. Die zeitliche Entwicklung dieser Kernspins der Probe erzeugt wiederum hochfrequente elektromagnetische Felder, welche in der NMR-Apparatur detektiert werden. Aus den detektierten Hochfrequenz (=HF)-Feldern können Informationen über die Eigenschaften der Probe erhalten werden.

Durch die Verwendung gekühlter Magnetresonanz-Probenköpfe konnte in den vergangenen Jahren die Empfindlichkeit in der hochauflösenden NMR-Spektroskopie erheblich gesteigert werden. Dies gilt insbesondere für die Hochfeld NMR, d.h. NMR mit statischen Magnetfeldern über 7 T, insbesondere über 11 T. Dabei werden bei diesen Probenköpfen die Empfangsspulen sowie die Empfangselektronik auf kryogene Temperaturen (unter 100 K) abgekühlt. Dadurch wird das thermische Rauschen von resistiven Elementen reduziert. Weiterhin wird durch die Kühlung der HF(Hochfrequenz)-Widerstand von Metallen gesenkt, so dass die Kühlung auch eine Steigerung der Güte von HF-Resonatorspulen im NMR-Probenkopf bewirkt.

Ein konstruktives Problem bei gekühlten Probenköpfen stellt die Temperierung der Messprobe dar, die in der Regel nahe Raumtemperatur (-40 bis 200°C, typisch um 20°C) gehalten werden soll. Aus Ref. [3] ist ein Probenkopf bekannt, bei dem eine zu kühlende, im Wesentlichen kreiszylindermantelförmige HF-Resonatorspule an einer gekühlten Plattform befestigt und in einem Vakuumbehälter, auch bezeichnet als Vakuumdewar, angeordnet wird. Der Vakuumdewar besitzt eine kreiszylinderförmige Ausnehmung, die das Innere der HF-Resonatorspule durchragt und in der eine Messprobe, etwa ein rundes Probenröhrchen gefüllt mit einer zu untersuchenden Probensubstanz, angeordnet wird. Dabei verbleibt zwischen der Wand des Probenröhrchens und der Dewarwand der Ausnehmung ein Lüftungsspalt (Temperierungsspalt). Durch den Lüftungsspalt wird ein Fluss von Temperiergas (etwa Luft oder Stickstoff) eingestellt, mit dem die Messprobe auf eine gewünschte Temperatur gebracht wird. Dabei muss die Messprobe sorgfältig zentriert sein, um einen ungleichmäßigen Wärmeeintrag oder eine ungleichmäßige Wärmeabfuhr zu verhindern. Weiterhin verbleibt zwischen der Dewarwand der Ausnehmung und der HF-Resonatorspule ein Isolationsspalt, der die Ausbildung einer Wärmebrücke unterbindet. Die Dewarwand der Ausnehmung, die die Messprobe umschließt, wird auch als Zentralrohr bezeichnet.

Die Empfindlichkeit eines NMR-Probenkopfs hängt neben der Güte (d.h. dem elektrischen Widerstand) und der Temperatur der Empfangsspule auch von der Effizienz (Feld pro Einheitsstrom im Messvolumen) oder dem Füllfaktor (Nutzenergie im Messvolumen geteilt durch Gesamtenergie) ab. Effizienz/Füllfaktor sind um so besser, je größer der Anteil des Messvolumens am Spulenvolumen ist. Auch wenn der Füllfaktor in der Literatur eine gängige Grösse ist, so ist seine quantitative Verwendung problematisch, da das Verhalten beim Skalieren der Messprobe anders ist als beim Skalieren der Spule. Da diese Grösse sehr anschaulich ist soll sie hier ebenfalls verwendet werden.

Beim Probenkopf aus Ref. [3] begrenzen insbesondere der Lüftungsspalt und die Dewarwandstärke die erreichbare Effizienz bzw. den erreichbaren Füllfaktor. Die Dewarwand hat aus fertigungstechnischen und mechanischen Gründen eine Mindeststärke, unabhängig von der Größe der Ausnehmung bzw. der Größe der Messprobe. Ebenso muss der Temperierungsspalt eine Mindestbreite aufweisen, um einen ausreichenden Fluss von Temperiergas sicherstellen zu können, ebenfalls im Wesentlichen unabhängig von der Größe der Messprobe. Besonders bei Messproben mit kleinem Durchmesser (kleiner 5 mm) nehmen Lüftungsspalt und Dewarwand einen erheblichen Teil des Spulenvolumens ein, so dass bei Messproben mit kleinem Durchmesser nur eine geringe Effizienz/ein geringer Füllfaktor erreichbar ist.

Um bei kleinen Messproben die geringe Effizienz/den geringen Füllfaktor zu kompensieren, ist es bekannt, supraleitende Empfangsspulen aus Hochtemperatur-Supraleitermaterial (HTS) zu verwenden. HTS-Empfangsspulen weisen eine deutlich höhere Güte als vergleichbare Spulen aus Metall auf. Allerdings lassen sich HTS-Empfangsspulen für Magnetresonanz-Probenköpfe derzeit nur auf planaren Substraten fertigen. Solche planaren Empfangsspulen ragen quer zur Erstreckung des Zentralrohrs über das Zentrafrohr hinaus und besitzen daher eine schlechtere Effizienz/einen schlechteren Füllfaktor als kreiszylindermantelförmige Spulen. Die schlechte Effizienz/der schlechte Füllfaktor wird jedoch durch die höhere Güte der planaren HTS-Resonatorspulen überkompensiert.

Aus Ref. [5] ist eine Anordnung mit zwei parallelen, gegenüberliegenden HF-Resonatorspulen aus HTS bekannt, zwischen denen ein rundes Zentralrohr für eine Messprobe mit einem runden Probenröhrchen angeordnet ist. Die HF-Resonatorspulen sind etwa 2,5 mal so breit wie das Zentralrohr. Auch bei dieser Anordnung begrenzen die Wandstärke der Dewarwand und die Breite des Luftspalts zwischen Messprobe und Dewarwand den Abstand der beiden planaren HF-Resonatorspulen und damit die Effizienz/den Füllfaktor.

Die US 2004/0108852 A1 beschreibt abgeflachte NMR-Behälter für flüssige Proben und zughörige NMR-Spulen. In einer Ausführungsform wird ein im Querschnitt rechteckiger, dielektrischer Spulenträger von einer Sattelspule, die auf einer Quader-Oberfläche angeordnet ist, umschlossen. Die Spule kann für Tieftempertur-Anwendungen in einem Dewar angeordnet sein, dessen Innenfläche auf die Spulenform bzw. die Probenform abgestimmt ist.

Die EP 0 461 493 A2 beschreibt eine Probentemperiervorrichtung für die NMR-Spektroskopie, bei der ein Kühlmittelfluid an einem in einem Probenröhrchen angeordneten Messprobe von unten nach oben vorbeigeführt wird. Zusätzlich ist ein Bypasskanal eingerichtet, der einen Kühlmittelfluss am oberen Teil der Probe einrichtet.

### Aufgabe der Erfindung

Es ist die Aufgabe der vorliegenden Erfindung, einen Magnetresonanz-Probenkopf vorzustellen, mit dem insbesondere bei kleinen und runden Messproben eine Verbesserung der Empfindlichkeit erreicht wird. Dies ist insbesondere für die hochauflösende und Hochfeld NMR wichtig.

### Kurze Beschreibung der Erfindung

Diese Aufgabe wird gelöst durch einen Magnetresonanz-Probenkopf der eingangs genannten Art, der dadurch gekennzeichnet ist, dass
der Probenkopf einen zwischen den HF-Resonatorspulen angeordneten Zentralrohrblock umfasst, der eine in z-Richtung langgestreckte Ausnehmung für eine Messprobe aufweist, wobei die Gesamtheit der HF-Resonatorspulen symmetrisch um die Ausnehmung für die Messprobe angeordnet ist,
wobei der Zentralrohrblock den Vakuumbehälter teilweise begrenzt und die der Ausnehmung zugewandte Wand des Vakuumbehälters bildet, wobei die Ausnehmung außerhalb des Vakuumbehälters liegt,
wobei der Zentralrohrblock für eine Temperierung der Messprobe in der Ausnehmung ausgebildet und im Bereich zwischen den HF-Resonatorspulen eine größere Erstreckung in der x-Richtung als in der y-Richtung aufweist, und
wobei jede der HF-Resonatorspulen auf einem ebenen Substrat angeordnet und als Planarspule ausgebildet ist, welche parallel zur z-Richtung liegt.

Im Stand der Technik wird die Temperierung der Messprobe durch einen Fluss eines Temperiergases gewährleistet, wobei das Temperiergas die Messprobe (in der Regel ein rundes Probenröhrchen gefüllt mit einer zu untersuchenden Probensubstanz) unmittelbar und allseitig umströmt. Das Temperiergas strömt dabei durch einen Lüftungsspalt, der ringförmig um die gesamte Messprobe herum belassen ist. Der Lüftungsspalt stellt einen Teil des Spulenvolumens dar, der nicht von der Messprobe eingenommen werden kann und somit stets die Effizienz/den Füllfaktor verschlechtert.

Im Rahmen der Erfindung wurde erkannt, dass der ringförmige Lüftungsspalt für die Temperierung der Messprobe verzichtbar ist. Die Temperierung der Messprobe kann vollständig oder teilweise über den Zentralrohrblock bzw. die messprobenzugewandte Wand des Zentralrohrblocks erfolgen. Dabei wird der Zentralrohrblock in den Wärmefluss von oder zu der Messprobe einbezogen. Die Mittel, mit denen der Zentralrohrblock den Wärmefluss von oder zu der Messprobe gewährleistet, werden im Rahmen der Erfindung in x-Richtung seitlich der Ausnehmung für die Messprobe im Zentralrohrblock angeordnet, daher benötigt der Zentralrohrblock erfindungsgemäß in x-Richtung eine größere Erstreckung als in y-Richtung. Dort ist für diese Mittel aufgrund der ebenfalls in x-Richtung längeren Erstreckung der Gesamtheit der HFresonatorspulen als in y-Richtung noch ausreichend Platz, der nicht als Messvolumen gebraucht wird.

Durch den Wegfall des Temperierungsspaltes können die HF-Resonatorspulen näher an die Messprobe heranrücken, insbesondere in y-Richtung. Damit einher geht eine Verringerung des Spulenvolumens (bei gleichbleibendem Messvolumen), wodurch die Effizienz/der Füllfaktor der HF-Resonatorspulen gesteigert wird. Dies führt zu einem verbesserten Signal zu Rauschverhältnis des Magnetresonanz-Probenkopfs, sowie zu kürzeren Pulszeiten für denselben Pulswinkel bei gleicher Leistung.

Die Mittel, mit denen der Zentralrohrblock einen Wärmefluss von oder zu der Messprobe gewährleistet, sind im einfachsten Fall die massive Struktur des Zentralrohrs selbst. Zusätzliches Zentralrohrblock-Material seitlich der Ausnehmung verbessert die Wärmeleitung (typischerweise in z-Richtung) aus dem beengten Messbereich zwischen den HF-Resonatorspulen heraus; außerhalb des Messbereichs kann eine Wärmesenke oder Wärmequelle (beispielsweise ein elektrischer Heizer) am Zentralrohrblock angeordnet werden.

Bevorzugt umfassen jedoch die Mittel, mit denen der Zentralrohrblock einen Wärmefluss von oder zu der Messprobe gewährleistet, mindestens eine Kühlmittelführung oder Kühlmittelleitung im Zentralrohrblock in x-Richtung seitlich der Ausnehmung, wobei in der Kühlmittelführung ein Kühlmittel (typischerweise ein temperiertes Gas wie Luft oder Stickstoff, oder auch eine temperierte Flüssigkeit wie Wasser) fließt. Mit dem Kühlmittel wird der Zentralrohrblock und gegebenenfalls auch unmittelbar ein Teil der Messprobe temperiert. Das Kühlmittel wird außerhalb des Zentralrohrblocks mit einer Wärmesenke oder Wärmequelle (beispielsweise ein elektrischer Heizer) temperiert.

Der Zentralrohrblock temperiert seinerseits die in seiner Ausnehmung angeordnete Messprobe über einen direkten (bevorzugt flächigen) Kontakt und/oder über Wärmestrahlung. Vor allem bei kleineren Messproben (Probendurchmesser 3 mm oder weniger) ist eine Temperierung über Wärmestrahlung allein oftmals ausreichend. Bevorzugt umschließt der Zentralrohrblock in der xy-Ebene die Messprobe vollständig, d.h. die Ausnehmung wird in der xy-Ebene allseits vom Zentralrohrblock begrenzt. Die Ausnehmung ist typischerweise im Wesentlichen zylinderförmig ausgebildet.

Aufgrund einer in x-Richtung seitlich der Ausnehmung massiveren Bauweise des Zentralrohrblocks kann auch die Wandstärke des Zentralrohrblocks an der Ausnehmung in y-Richtung verringert werden; dadurch können ebenfalls die HF-Resonatorspulen in y-Richtung näher an die Messprobe heranrücken.

Erfindungsgemäß sind die HF-Resonatorspulen typischerweise aus Supraleitermaterial, bevorzugt HTS gefertigt, um eine optimale Güte zu erreichen. Die HF-Resonatorspulen sind im Allgemeinen auf ebenen Substraten angeordnet. Ihre Resonanzfrequenzen liegen in der Regel im Bereich 20 MHz bis 1.5 GHz.

Der Zentralrohrblock weist ein Verhältnis der x-Erstreckung zur y-Erstreckung von typischerweise 1,2 oder mehr (und bevorzugt 1,5 oder mehr) auf. Ebenso weist die Gesamtheit der HF-Resonatorspulen typischerweise ein Verhältnis der x-Erstreckung zur y-Erstreckung von 1,2 oder mehr (und bevorzugt 1,5 oder mehr) auf. In der Regel verlaufen die x-Richtung und die y-Richtung entlang von Hauptachsen bzw. Symmetrieachsen von Zentralrohrblock und Gesamtheit der HF-Resonatorspulen; beispielsweise verläuft bei einem im Querschnitt in der xy-Ebene näherungsweise rechteckförmigen Zentralrohrblock die x-Achse parallel den längeren Seitenkanten und die y-Achse parallel den kürzeren Seitenkanten.

Eine Messprobe, die in der Ausnehmung angeordnet wird, weist typischerweise in x-Richtung und y-Richtung den gleichen (maximalen) Durchmesser auf. Die Messprobe ist in z-Richtung regelmäßig entsprechend der Form der Ausnehmung langgestreckt.

Gemäß der Erfindung ist die Gesamtheit der HF-Resonatorspulen symmetrisch um die Ausnehmung für die Messprobe angeordnet, wobei die Gesamtheit der HF-Resonatorspulen spiegelsymmetrisch bezüglich einer xz-Ebene, und bevorzugt auch spiegelsymmetrisch bezüglich einer yz-Ebene angeordnet ist. Die Ausnehmung bzw. die Messprobe liegt dann mittig im Zentralrohrblock in einem Bereich hoher Magnetfeldhomogenität.

### Bevorzugte Ausführungsformen der Erfindung

Besonders bevorzugt ist eine Ausführungsform des erfindungsgemäßen Magnetresonanz-Probenkopfs, bei dem in der Ausnehmung für eine Messprobe eine Messprobe angeordnet ist, insbesondere wobei die Messprobe einen kreisrunden Querschnitt bezüglich der xy-Ebene hat.

Bevorzugt ist auch eine Ausführungsform, bei der die Messprobe in der xy-Ebene einen maximalen Durchmesser von 3 mm oder weniger aufweist. Gerade bei solch kleinen Probendurchmessern macht sich der Effizienzgewinn der HF-Resonatoren durch die Erfindung besonders bemerkbar.

Eine Weiterbildung dieser Ausführungsform sieht vor, dass der Durchmesser der Messprobe in y-Richtung gleich ist dem Durchmesser der Ausnehmung in y-Richtung. Die Erstreckung der Ausnehmung in y-Richtung innerhalb der Gesamtheit der HF-Resonatoren wird dann vollständig genutzt, wodurch ein hoher Füllfaktor erreicht wird. Typischerweise liegt dabei die Messprobe mit Kanten, die den HF-Resonatorspulen zugewandt sind, an der Wand der Ausnehmung an.

Eine andere bevorzugte Ausführungsform des erfindungsgemäßen Magnetresonanz-Probenkopfs ist dadurch gekennzeichnet, dass zwei HF-Resonatorspulen vorgesehen sind, die jeweils als Planarspulen in einer xz-Ebene ausgebildet sind, und dass die zwei HF-Resonatorspulen in y-Richtung beabstandet sind und einander gegenüberliegen. Dieser Aufbau ist besonders einfach, und durch die Erfindung kann der Abstand der HF-Resonatorspulen in y-Richtung deutlich reduziert werden. Bei dieser Ausführungsform sind typischerweise genau die obigen zwei HF-Resonatorspulen vorgesehen, wobei die x-Erstreckung des Zentralrohrblocks im Wesentlichen x-Erstreckung der HF-Resonatorspulen entspricht.

Bei einer Weiterbildung dieser Ausführungsform weist der Zentralrohrblock zwei den zwei HF-Resonatorspulen zugewandte ebene Außenflächen auf, die jeweils in einer xz-Ebene liegen. Dadurch kann der Raum zwischen den HF-Resonatorspulen optimal ausgefüllt werden, insbesondere durch den Zentralrohrblock.

Bei einer anderen, bevorzugten Ausführungsform sind vier planare HF-Resonatorspulen vorgesehen, die im Querschnitt bezüglich der xy-Ebene die Gestalt zweier mit ihren offenen Seiten aufeinander zu gerichteter "V"s aufweisen. Diese Anordnung hat von vorne herein einen hohen Füllfaktor, der durch die Erfindung noch weiter vergrößert werden kann.

Vorteilhaft ist auch eine Ausführungsform, bei der der Zentralrohrblock in der xy-Ebene einen abgerundeten Außenquerschnitt zum Vakuumbehälter aufweist, insbesondere wobei der Außenquerschnitt vollständig oder abschnittsweise elliptisch oder oval ausgebildet ist. Durch die Vermeidung von Kanten, insbesondere rechtwinkligen Kanten, ist die Ausnehmung gegenüber dem Vakuumbehälter mittels O-Ringen, Indium- oder Kupferringen und dergleichen leichter abzudichten.

Besonders bevorzugt ist eine Ausführungsform, bei der der Zentralrohrblock aus einem Material mit einer Wärmeleitfähigkeit ≥ 5 W/(m*K), insbesondere aus Saphir, amorphem Aluminiumoxyd, Aluminiumnitrid, Berylliumoxyd, Bornitrid , Magnesiumoxyd oder Werkstoffen, die diese Materialien enthalten, insbesondere spanbearbeitbare Keramiken wie Shapal besteht. Dadurch wird der Wärmefluss von oder zu der Messprobe über den Zentralrohrblock verbessert.

Bei einer bevorzugten Ausführungsform weist der Zentralrohrblock zwei mit Rillen versehenen Halbschalen auf, die in der xz-Ebene aneinander befestigt, insbesondere miteinander verklebt, verschmolzen oder verlötet, sind. Ein solcher Zentralrohrblock ist einfach und kostengünstig zu fertigen.

Vorteilhaft ist auch eine Ausführungsform, bei der der Zentralrohrblock eine elektrisch leitfähige Beschichtung aufweist. Die Beschichtung kann als elektrischer Heizer eingesetzt werden. Es kann auch eine Beschichtung des Zentralrohrs vorgesehen sein, die Wärmestrahlung reflektiert und somit die Wärmelast des Zentralrohrs reduziert.

Bei einer anderen vorteilhaften Ausführungsform ist der Zentralrohrblock mit elektrisch nichtleitenden Fasern umgeben. Die Fasern bilden eine Superisolation mittels Schwarzkörperstrahlung.

### Kühlmittelführung

Ganz besonders bevorzugt ist eine Ausführungsform des erfindungsgemäßen Magnetresonanz-Probenkopfs, die vorsieht, dass im Zentralrohrblock mindestens eine Kühlmittelführung vorgesehen ist, dass in der Ausnehmung für eine Messprobe eine Messprobe angeordnet ist, dass im Bereich zwischen den HF-Resonatorspulen die mindestens eine Kühlmittelführung seitlich der Messprobe in Hinblick auf die x-Richtung verläuft, und dass sich im Bereich zwischen den HF-Resonatorspulen die mindestens eine Kühlmittelführung in y-Richtung vollständig innerhalb des Bereichs der y-Erstreckung der Messprobe befindet. Über die Kühlmittelführung kann eine besonders leistungsstarke Wärmezufuhr oder Wärmeabfuhr erfolgen. Durch die in x-Richtung seitliche Anordnung der Kühlmittelführung, wobei die Kühlmittelführung in y-Richtung nicht über Messprobe hinaus ragt, bestimmt nur die Messprobe die notwendige y-Erstreckung des Zentralrohrblocks. Dadurch ist ein hoher Füllfaktor möglich.

Bei einer bevorzugten Weiterbildung dieser Ausführungsform weist die mindestens eine Kühlmittelführung im Bereich zwischen den HF-Resonatorspulen zwei Führungsabschnitte auf, die bezüglich der x-Richtung zu beiden Seiten der Messprobe verlaufen. Durch die beidseitige Temperierung werden Temperaturgradienten in der Messprobe vermindert, und ein symmetrischer Aufbau des Zentralrohrblocks ist leicht möglich.

Bei einer weiteren, bevorzugten Weiterbildung weist die mindestens eine Kühlmittelführung eine Mehrzahl von aufeinanderfolgenden Führungsabschnitten, insbesondere wenigstens vier aufeinanderfolgende Führungsabschnitte, auf, zwischen denen sich jeweils die Verlaufsrichtung der Kühlmittelführung ändert. Dadurch können Temperaturgradienten im Zentralrohrblock weiter vermindert werden.

### Separate Kühlmittelführungen

Bei einer ganz besonders bevorzugten Weiterbildung ist die mindestens eine Kühlmittelführung von der Ausnehmung für die Messprobe separat. Dies macht den Kühlmittelfluss in der Kühlmittelführung leicht beherrschbar. Die Temperierung der Messprobe erfolgt dann nur über den Zentralrohrblock bzw. die messprobenzugewandte Wand der Ausnehmung.

### Flusszelle

Bei einer Fortentwicklung dieser Weiterbildung ist die Ausnehmung für die Messprobe als Flusszelle ausgebildet, insbesondere wobei die Ausnehmung mit einer fließfähigen Probensubstanz als Messprobe unmittelbar gefüllt ist. Ein Probengefäß für die Messprobe im Zentralrohrblock ist dann unnötig, wodurch der Anteil an Probensubstanz im Spulenvolumen vergrößert ist.

Dabei ist bevorzugt die Flusszelle als Rotationsellipsoid mit einer Rotationsachse parallel zur z-Richtung ausgebildet. Dadurch wird ein homogenes Magnetfeld der Messprobe erreicht.

Ebenfalls bevorzugt ist es, wenn die Flusszelle sich zu ihren Zuführungen hin verengt. Dadurch kann das Volumen der Probensubstanz außerhalb des Messbereichs reduziert werden.

### Probengefäß

Eine besonders bevorzugte Fortentwicklung der Weiterbildung, die eine separate Kühlmittelführung vorsieht, ist dadurch gekennzeichnet, dass in der Ausnehmung für eine Messprobe eine Messprobe angeordnet ist, und dass die Messprobe ein Probengefäß umfasst, das mit einer Probensubstanz befüllt ist. Diese Anordnung ist in der Praxis bewährt und gestattet gute und schnelle Messprobenhandhabung. Die Probensubstanz kann eine Flüssigkeit (typischerweise enthaltend ein Lösungsmittel) oder auch eine Festkörperprobe (typischerweise ein Pulver) sein. Das Probengefäß ist in der Regel ein rundes Probenröhrchen.

Bevorzugt liegt das Probengefäß zumindest im Bereich zwischen den HF-Resonatorspulen abschnittweise oder vollständig flächig an der Wand der Ausnehmung des Zentralrohrblocks an. Der Kontakt verbessert den Wärmeübertrag zwischen Zentralrohrblock und Probengefäß (und damit der Probensubstanz). Typischerweise füllt das Probengefäß die Ausnehmung vollständig aus. Eine entsprechende Ausführung kommt auch bei nichtseparaten Kühlmittelführungen in Betracht.

Bevorzugt ist auch vorgesehen, dass die Ausnehmung als eine durchgehende Bohrung durch den Zentralrohrblock ausgebildet ist,
dass die Bohrung einenends mit einem Stopfen verschlossen ist, wobei das dem Probengefäß zugewandte Ende des Stopfens parallel zum dem Stopfen zugewandten Ende des Probengefäßes gekrümmt ist, und dass die magnetische Suszeptibilität des Materials des Stopfens der magnetischen Suszeptibilität der Messprobe entspricht. Dadurch kann eine gute Magnetfeldhomogenität in der Probensubstanz erreicht werden

Alternativ kann die Ausnehmung als Sackloch im Zentralrohrblock ausgebildet ist. Dies ist einfach zu fertigen.

### Überlappende Bohrungen

Eine bevorzugte Weiterbildung der Ausführungsform, die mindestens eine Kühlmittelführung vorsieht, ist dadurch gekennzeichnet, dass die Ausnehmung für die Messprobe auch die mindestens eine Kühlmittelführung umfasst, dass in der Ausnehmung für eine Messprobe eine Messprobe angeordnet ist, dass die Messprobe ein Probengefäß umfasst, das eine Probensubstanz enthält, und dass das Probengefäß die mindestens eine Kühlmittelführung teilweise begrenzt. Bei dieser Weiterbildung erfolgt die Temperierung der Messprobe teilweise unmittelbar durch vorbeiströmendes Kühlmittel, was den Wärmefluss verbessert; die Anforderungen an die Wärmeleitfähigkeit des Zentralrohrblocks sind dann verringert. Im Zentralrohrblock wird außerdem weniger Platz für Wände (etwa für die Kühlmittelführung) gebraucht, wodurch der Füllfaktor gesteigert werden kann.

Bei einer Fortentwicklung dieser Weiterbildung sind in der Ausnehmung Zentrierungselemente und/oder Anschlagselemente vorgesehen, die das Probengefäß beim Einführen in die Ausnehmung in der xy-Ebene und/oder in z-Richtung positionieren. Durch die Positionierung wird ein homogenes Magnetfeld in der Messprobe sichergestellt.

Dabei sind bevorzugt die Zentrierungselemente und/oder Anschlagelemente aus einem Material mit magnetischer Suszeptibilität entsprechend der Volumensuszeptibilität eines Kühlmittels der Kühlmittelführung hergestellt, insbesondere wobei in der Kühlmittelführung Luft mit 0,4 ppm in Sl-Einheiten oder Stickstoff mit -0,0064 ppm in Sl-Einheiten vorgesehen ist. Dadurch wird eine Verzerrung des statischen Magnetfelds durch die Zentrierungselemente und Anschlagelemente vermieden.

Die Zentrierungselemente können auch zumindest im Bereich des HF-Feldes der Resonatorspulen als in z-Richtung verlaufende, durchgehende Stangen ausgebildet sein. Dies verhindert ebenfalls Magnetfeldverzerrungen.

Eine andere Fortentwicklung sieht vor, dass der Zentralrohrblock mindestens im Bereich des HF-Feldes der Resonatorspulen eine im Querschnitt bezüglich der xy-Ebene konstante Wandstärke aufweist. Der Zentralrohrblock ist dann besonders einfach zu fertigen, insbesondere unter Verwendung von Glas- und Kunststoffmaterialien und Guss- sowie Umformungsverfahren.

### Sonstiges

Bei einer weiteren Ausführungsform eines erfindungsgemäßen Magnetresonanz-Probenkopfs ist die Ausnehmung für die Messprobe im Wesentlichen zylinderförmig mit der Zylinderachse in z-Richtung ausgebildet. Dadurch wird eine hohe Homogenität des Magnetfelds in der Messprobe ermöglicht.

In den Rahmen der vorliegenden Erfindung fällt auch eine NMR(Kernspinresonanz)-Messapparatur, umfassend ein Magnetsystem zur Erzeugung eines homogenen statischen Magnetfelds B₀ in z-Richtung und ein NMR-Spektrometer mit einen erfindungsgemäßen Magnetresonanz-Probenkopf. Mit einer solchen Messapparatur können sehr genaue spektroskopische Daten über eine Messprobe erhalten werden.

Weitere Vorteile der Erfindung ergeben sich aus der Beschreibung und den Zeichnungen. Die gezeigten und beschriebenen Ausführungsformen sind nicht als abschließende Aufzahlung zu verstehen, sondem haben vielmehr beispielhaften Charakter für die Schilderung der Erfindung.

### Zeichnung und detaillierte Beschreibung der Erfindung

Die Erfindung ist in der Zeichnung näher dargestellt und erläutert. Es zeigen:
- Fig. 1: eine schematische Querschnittsdarstellung durch einen Magnetresonanz(MR)-Probenkopf des Standes der Technik mit runder HF-Resonatorspule mit kreisrundem Zentralrohr;
- Fig. 2: eine schematische Querschnittsdarstellung durch einen MR-Probenkopf des Standes der Technik mit planaren HF-Resonatorspulen aus HTS mit kreisrundem Zentralrohr;
- Fig. 3: eine schematische Querschnittsdarstellung durch einen erfindungsgemäßen MR-Probenkopf mit planaren HF-Resonatorspulen aus HTS und mit einem in x-Richtung verbreitertem Zentralrohrblock;
- Fig. 4a-4c: schematische Querschnittsdarstellungen eines weiteren erfindungsgemäßen MR-Probenkopfs;
- Fig. 5: eine schematische Querschnittsdarstellung eines weiteren erfindungsgemäßen MR-Probenkopfs mit vier planaren HF-Resonatorspulen, von denen je zwei nebeneinander und auf einer Seite des Zentralrohrblocks angeordnet sind;
- Fig. 6: eine schematische Querschnittsdarstellung eines weiteren erfindungsgemäßen MR-Probenkopfs mit vier planaren HF-Resonatorspulen, die im Querschnitt rautenförmig angeordnet sind;
- Fig. 7: eine schematische Querschnittsdarstellung eines Zentralrohrblocks für die Erfindung, mit rechteckförmigem Querschnitt;
- Fig. 8: eine schematische Querschnittsdarstellung eines weiteren Zentralrohrblocks für die Erfindung, mit abgerundetem Außenquerschnitt;
- Fig. 9: eine schematische Querschnittsdarstellung eines weiteren Zentralrohrblocks für die Erfindung, gefertigt aus zwei Halbschalten und mit im Querschnitt quadratischer Ausnehmung für eine Messprobe und rechteckförmigen Kühlmittelführungen;
- Fig. 10: eine schematische Querschnittsdarstellung eines weiteren Zentralrohrblocks für die Erfindung, gefertigt aus zwei Halbschalten, mit abgerundeten Bohrungen;
- Fig. 11: eine schematische Querschnittsdarstellung eines weiteren Zentralrohrblocks für die Erfindung, mit einer gemeinsamen Ausnehmung für Messprobe und Kühlmittelführungen, mit abgerundetem Außenquerschnitt und konstanter Wandstärke;
- Fig. 12: eine schematische Querschnittsdarstellung eines weiteren Zentralrohrblocks für die Erfindung, mit einer gemeinsamen Ausnehmung für Messprobe und Kühlmittelführungen in Gestalt von überlappenden, runden Bohrungen;
- Fig. 13a-13b: schematische Querschnittsdarstellungen eines weiteren Zentralrohrblocks für die Erfindung, mit konstanter Wandstärke, und mit Zentriereinrichtung und Verdrängungskörper;
- Fig. 14a-14b: schematische Querschnittsdarstellungen eines weiteren Zentralrohrblocks für die Erfindung, mit konstanter Wandstärke, und mit Führungsstangen und Verlängerung;
- Fig. 15a-15c: schematische Querschnittsdarstellungen eines weiteren Zentralrohrblocks für die Erfindung, mit Sackloch;
- Fig. 16a-16c: schematische Querschnittsdarstellungen eines weiteren Zentralrohrblocks für die Erfindung, mit durchgehender Bohrung und suszeptibilitäts-angepasstem Stopfen;
- Fig.17: eine schematische Querschnittsdarstellung eines Zentralrohrblocks für die Erfindung, massiv ohne Kühlmittelführung;
- Fig. 18a-18c: schematische Querschnittsdarstellungen eines weiteren Zentralrohrblocks für die Erfindung, mit als zylinderförmige Flusszelle ausgebildeter Ausnehmung;
- Fig. 19: eine schematische Querschnittsdarstellung eines weiteren Zentralrohrblocks für die Erfindung, mit als rotationsellipsoide Flusszelle ausgebildeter Ausnehmung;
- Fig. 20: eine schematische Querschnittsdarstellung eines weiteren Zentralrohrblocks für die Erfindung, mit als kugelförmige Flusszelle ausgebildeter Ausnehmung.

Die Erfindung betrifft einen Vakuumbehälter für einen gekühlten Magnetresonanz-Probenkopf.

### Hintergrund und Stand der Technik

In den vergangenen Jahren konnte die Empfindlichkeit der hochauflösenden Kernspinresonanz (NMR)-Spektroskopie und NMR-Mikroskopie durch die Verwendung gekühlter Magnetresonanz-Probenköpfe massiv gesteigert werden.

In der Regel werden bei diesen Probenköpfen die Empfangsspulen sowie die Empfangselektronik auf kryogene Temperaturen, d.h. Temperaturen unter 100 K abgekühlt. Durch die Kühlung wird einerseits das thermische Rauschen der resistiven Elemente reduziert und andererseits sinkt auch der HF-Widerstand von Metallen. Weiterhin wird die Verwendung von Supraleitern für die Sende-/Empfangsspulen ermöglicht. Gekühlte Elektronik kann mit niedrigerer Rauschtemperatur gefertigt werden als herkömmliche Elektronik.

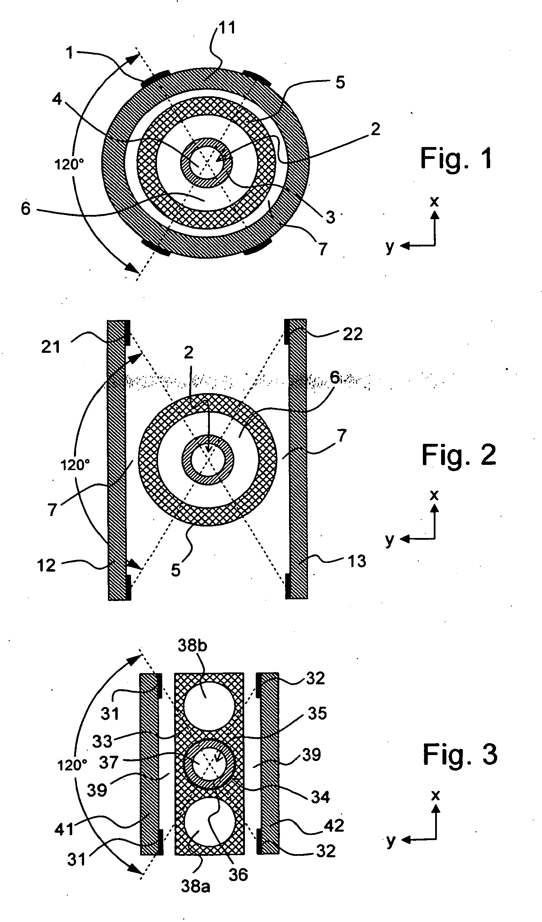

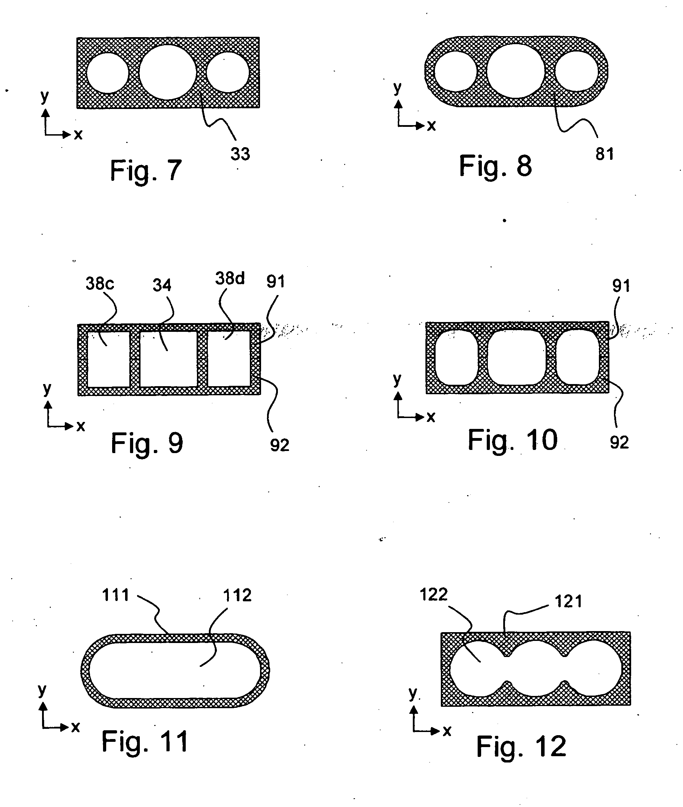

Eines der größten Probleme gekühlter Magnetresonanz-Probenköpfe stellt sich durch die Anforderung, kryogene Temperaturen für die Sende-/Empfangsspulen zu erreichen und zugleich die Messproben nahe der Raumtemperatur (-40 bis +200 °C) zu halten, da die Messsubstanzen (oder Messobjekte in der Mikroskopie) in der Regel in flüssigen Lösungsmitteln (Wasser, Aceton, Methanol, Chloroform, Benzol, ...) gelöst sind. Die gängige Lösung in der Kryotechnik ist entweder einen Vakuumdewar zu bauen und die zu kühlenden Elemente entweder mit flüssigem oder gasförmigem Kühlmittel zu umgeben (vgl. Ref. [4a], dortige Fig. 2b), oder die zu kühlenden Elemente an einer gekühlten Plattform (Kältefinger) zu befestigen und in Vakuum zu isolieren (vgl. Ref. [3], dortige Fig. 7). Es sind auch besondere Ausführungsformen der zweiten Art bekannt, bei denen das Kühlmittel direkt im Inneren der Sende-/Empfangsspulen fliesst.
Im ersten Fall trennen zwei Wände und ein Isolationsvakuum die Messprobe von der Empfangsspule, im zweiten Fall lediglich eine Wand. Da der benötigte Platz der zweiten Lösung deutlich kleiner ist als der der ersten Lösung, wird in der Regel die zweite bevorzugt.

Es bleibt anzumerken, dass in beiden Fällen zusätzlicher Raum (verglichen mit Raumtemperatur-Probenköpfen) benötigt wird: Damit die Messprobe thermalisiert werden kann, wird sie in der Regel mittels eines Gasstromes gewärmt (bzw. gekühlt). Für diesen Gasstrom wird ein ringförmiger Temperierungsspalt um die Messprobe eingerichtet. Weiterhin wird zumindest im Falle der Verwendung eines Kältefingers noch freier Raum (Vakuumspalt oder Isolationsspalt) zwischen der Wand des Vakuumdewars und der Empfangsspule benötigt, um eine Wärmebrücke zu vermeiden (im ersten Falle der Kühlung der mittels flüssigem oder gasförmigem Kühlmittel ist dieser lsolationsspalt in der Dewarwand integriert).

Die Kühlung mittels Gasstromes ist jedoch nicht unproblematisch: Einerseits führt eine unpräzise Zentrierung der Messprobe und/oder eine Berührung mit dem Zentralrohr zu Temperaturgradienten, die bei manchen Messsubstanzen mit temperaturabhängigen Kopplungen zu Artefakten führen, andererseits ist der Gasstrom und damit die Heiz- oder Kühlleistung begrenzt, da zu hohe Strömungsgeschwindigkeiten zu Vibrationen oder sogar dem Abheben der Messprobe führen. Anordnungen, die diese Probleme auf ein tolerierbares Mass begrenzen sind z.B. aus Ref. [2], vgl. insbesondere dortige Fig. 7a, 7b, bekannt.

Die Empfindlichkeit von NMR-Probenköpfen hängt aber nicht nur von der Güte (d.h. vom elektrischen Widerstand) und der Temperatur der Empfangsspule ab, sondern auch von deren Effizienz (Feld pro Einheitsstrom im Messvolumen) oder Füllfaktor (Nutzenergie im Messvolumen geteilt durch die Gesamtenergie).
Die Effizienz wird im Folgenden auch mit η bezeichnet. Es ist offensichtlich, dass die Effizienz/der Füllfaktor mit einem zunehmenden Verhältnis von Spulenvolumen zu Messvolumen sinkt.

Bei Verwendung von im Querschnitt kreisrunden Messproben und Spulen vom kreisrunden Typ verhält sich die Empfindlichkeit des Probenkopfes, d.h. das erzielbare Signal zu Rauschverhältnis S/N, in etwa wie Rₛ/R_{c}, mit Rₛ: Radius der Messprobe (s="sample") und R_{c}: Radius der Spule (c="coil"), wenn alle anderen Parameter konstant gehalten werden. Der Füllfaktor verhält sich wie (Rₛ/R_{c})², unter der Bedingung, dass lediglich Rₛ variiert wird. Die Abhängigkeit ist kompliziert, wenn die Abmessungen der Spule skaliert werden (da sich unter anderem auch die Güte und die Induktivität L ändern). Daher ist der Füllfaktor als quantitative Grösse keine sinnvolle Definition, allerdings wird er häufig verwendet, da er eine sehr anschauliche Grösse ist. Die Effizienz η hingegen verhält sich beim Skalieren sowohl der Spule als auch der Messprobe wie (Rₛ/R_{c})².

Bei relativ grossen Messproben wie z.B. dem Standard-Probenröhrchen mit 5 mm Durchmesser wird ein Verlust an Effizienz/Füllfaktor gekühlter Probenköpfe gegenüber Raumtemperatur-Probenköpfen durch den Gewinn an Güte und Rauschtemperatur deutlich wett gemacht. Je kleiner die verwendeten Messproben im Durchmesser sind, desto ungünstiger wird allerdings das Verhältnis von Rₛ und R_{c}, da weder die Wandstärke des Vakuumbehälters noch die Breite von Temperierungsspalt und Vakuumspalt reduziert werden können. Die Gründe für die mehr oder weniger konstanten Wandstärken sind fertigungstechnischer und mechanischer Art. Der Spalt, der zum Fluss des Temperiergases vorgesehen ist, kann nicht reduziert werden, da die abzuführende Kälte pro Raumwinkel bei Reduktion des Probendurchmessers konstant bleibt.

Eine schematische Querschnittsansicht eines herkömmlichen Cryo-Probenkopfs senkrecht zur z-Achse, in der ein starkes statisches Magnetfeld B₀ anliegt, zeigt die **Figur 1**. Der Cryo-Probenkopf verfügt über eine im Querschnitt im Wesentlichen ringförmige HF-Resonatorspule 1 (in der Figur sind davon vier Leiterquerschnitte zu sehen), die auf einem zylindermantelförmigen Substrat 11 angeordnet ist. Radial innerhalb der HF-Resonatorspule 1 ist eine runde Messprobe 2 angeordnet, umfassend ein Probengefäß 3 und einen mit einer Probensubstanz 4 gefüllten Innenraum des Probengefäßes 3. Zwischen Messprobe 2 und HF-Resonatorspule 1 liegt eine runde, einheitlich starke Wand 5 eines Vakuumbehälters, in dem die HF-Resonatorspule 1 angeordnet ist. Die Wand 5 wird auch als Zentralrohr bezeichnet. Der Vakuumbehälter dient der thermischen Isolation der HF-Resonatorspule 1, die über einen nicht dargestellten Kühlfinger gekühlt wird. Zwischen Wand 5 und Messprobe 2 ist ein ringförmiger Temperierungsspalt 6, in dem ein Gasstrom strömt (in z-Richtung senkrecht zur Zeichenebene). Der Gasstrom temperiert die Messprobe 2. Da mit dem Gasstrom gleichzeitig auch die Wand 5 erwärmt wird, besteht auch ein lsolationsspalt 7 zwischen der Wand 5 und der HF-Resonatorspule 1 bzw. deren Substrat 11. Dies vermeidet eine Wärmebrücke zur gekühlten HF-Resonatorspule 1.

Bei kleiner werdendem Durchmesser der Messprobe 2 verringert sich das Messvolumen stärker als das Spulenvolumen verringert werden kann (vgl. dazu die Querschnitts-Innenflächen von Messprobe 2 und HF-Resonatorspule 1), so dass die Effizienz η_{cryo} zu kleineren Probendurchmessern hin abnimmt. Bei Raumtemperatur (RT) Probenköpfen bleibt hingegen das Verhältnis von Messvolumen und Spulenvolumen auch bei abnehmendem Durchmesser einer Messprobe fast gleich, da eine HF-Resonatorspule im RT-Fall unmittelbar an die Messprobe heranrücken kann.

Um bei kleinen Messproben den extrem ungünstigen Füllfaktor zu kompensieren, gibt es die Möglichkeit, supraleitende Empfangsspulen aus HTS (Hochtemperatursupraleiter) zu verwenden. Diese Spulen haben eine deutlich höhere Güte als vergleichbare Spulen aus Metall, weisen aber den Nachteil auf, dass HTS, mit für den Einsatz in Magnetresonanzprobenköpfen geeigneten Materialparametern, derzeit lediglich auf planaren Substraten gefertigt werden kann. Im Stand der Technik wurde auch bei diesen Probenköpfen ein an die Messprobe angepasstes rundes Zentralrohr verwendet (siehe Ref. [5], dortige Fig.1).

Durch den Einsatz planarer Substrate verschlechtert sich aber die Effizienz der Spulen bei gleichem Probendurchmesser im Vergleich zu Spulen von herkömmlichen Cryo-Probenköpfen um einen Faktor von typischerweise 3-4.

**Fig. 2** zeigt eine Querschnittsansicht eines HTS-Cryo-Probenkopfs des Standes der Technik vergleichbar Ref. [5] senkrecht zur z-Achse. Zwischen zwei planaren HTS-HF-Resonatorspulen 21, 22 (wiederum sind im Querschnitt nur je zwei Leiterquerschnitte zu sehen, die auf planaren Substraten 12, 13 angeordnet sind) verläuft die Vakuumbehälter-Wand (das Zentralrohr) 5, innerhalb dessen wiederum ist die Messprobe 2 angeordnet. Zwischen Wand 5 und Messprobe 2 verbleibt auch hier ein Temperierungsspalt 6, und eine Lücke zwischen den planaren HF-Resonatorspulen 21, 22 und der Wand 5 kann als Isolationsspalt 7 aufgefasst werden.

Auch in diesem Fall verringert sich mit abnehmendem Durchmesser der Messprobe 2 das Messvolumen stärker als das Spulenvolumen verringert werden kann (vgl. den Raum innerhalb der Messprobe 2 und der Raum zwischen den Spulen 21, 22). Das Spulenvolumen ist erheblich größer als im Fall von Fig. 1, bei identisch großen Messproben 2.

Dennoch wird mit planaren HTS-Resonatorspulen bei kleinen Messproben einen markanten Gewinn an Empfindlichkeit des Probenkopfes erzielt, da das thermische Rauschen der Spulen eines HTS-Probenkopfes ca 15-20 mal geringer ist als das eines äquivalenten RT-Probenkopfes. Im Ergebnis sind mit HTS-HF-Resonatorspulen im Vergleich zu RT-HF-Resonatorspulen bei kleinen Messproben Empfindlichkeitssteigerungen von einem Faktor 3-6 möglich.

Der Öffnungswinkel von 120°, wie in Fig. 2 dargestellt ist nicht unbedingt notwendig. Eine ausreichende Feldhomogenität im Probenvolumen kann z.T. auch bei geringeren Öffnungswinkeln erreicht werden, so dass die HTS-Resonatoren auch schmaler ausgeführt werden können.

### Erfindungsgemäße Magnetresonanz-Probenköpfe

Die Erfindung besteht darin, bei Probenköpfen mit planaren HTS-HF-Resonatorspulen den Füllfaktor durch konstruktive Maßnahmen zu erhöhen. Dadurch kann die Empfindlichkeit des Probenkopfes deutlich gesteigert werden.

Zusammenfassend schlägt die Erfindung vor, beim Magnetresonanz-Probenkopf das Zentralrohr, in welchem die Probe bei einer NMR-Messung angeordnet ist und welches die Probe vom Vakuumbehälter trennt, in einer Richtung senkrecht zum B₀-Feld verbreitert auszuführen. In dieser Richtung ist im Innenraum der Gesamtheit der HF-Resonatorspulen des Probenkopfs ungenutzter Platz, insbesondere weil die HF-Resonatorspulen in dieser Richtung relativ weit entfernt von der Ausnehmung für die Messprobe im Zentralrohr liegen. Das verbreiterte Zentralrohr wird auch Zentralrohrblock genannt. Die Verbreiterung wird genutzt, um Mittel zur Temperierung für die Messprobe zu beherbergen. Die Messprobe wird zumindest teilweise über den Zentralrohrblock temperiert.

Die Erfindung sieht typischerweise vor die Verwendung eines Vakuumbehälters, umfassend
erstens einen Innenraum der eine äußere und eine innere zylinderförmige und parallel zur z-Achse und zur Richtung des B₀-Feldes verlaufende Grenzfläche besitzt, die oben und unten miteinander verbunden sind und dadurch den Innenraum abschließen,
und zweitens einen im Zentralbereich des Vakuumbehälters gelegenen Außenraum AR, der vom zylinderförmigen Teil der inneren Grenzfläche umschlossen ist,
und drittens mindestens ein kryogen gekühltes Spulen- / Resonatorsystem, das innerhalb des Innenraumes angeordnet ist und während des Messvorganges ein Hochfrequenzfeld B₁ im Bereich z₁ < z < z₂ im Außenraum AR erzeugt und/oder empfängt,
und viertens eine Messprobe, die im Außenraum AR positioniert und parallel zur z-Achse orientiert ist,
wobei die innere Grenzfläche mindestens im Bereich z₁ < z < z₂ eine senkrecht zur z-Achse orientierte Querschnittsfläche umschließt, deren orthogonale Achsen unterschiedliche Längen besitzen,
wobei das Spulen-/Resonatorsystem aus planaren Elementen aufgebaut ist, und wobei die Messprobe eine runde Querschnittsform besitzt.

Insbesondere beim Einsatz von Empfangsspulen, die auf planaren Substraten aufgebaut sind, macht es wenig Sinn, ein kreiszylinderförmiges Zentralrohr zu verwenden, selbst wenn die Messproben kreiszylinderförmig sind. Durch die Verwendung eines abgeflachten Zentralrohres (Zentralrohrblock), bei dem der ungenutzte Raum der planaren Spulen genutzt wird, um die Temperierung der Messproben zu gewährleisten und zugleich der "Luftspalt" (Temperierungsspalt) in der Richtung der Sende/Empfangsspule entfernt wird, kann insbesondere bei kleinen Messproben (1-3 mm) der Füllfaktor der Spulen markant gesteigert werden. Bei größeren Messproben fällt der Unterschied kleiner aus, da der durch Einsparen des Temperierungsspaltes gewonnene Abstand in Bezug auf die Gesamtabmessungen weniger ins Gewicht fällt; auch ist bei größeren Messproben die Temperierung ohne gleichmäßigen Gasfluss zunehmend schwerer realisierbar.

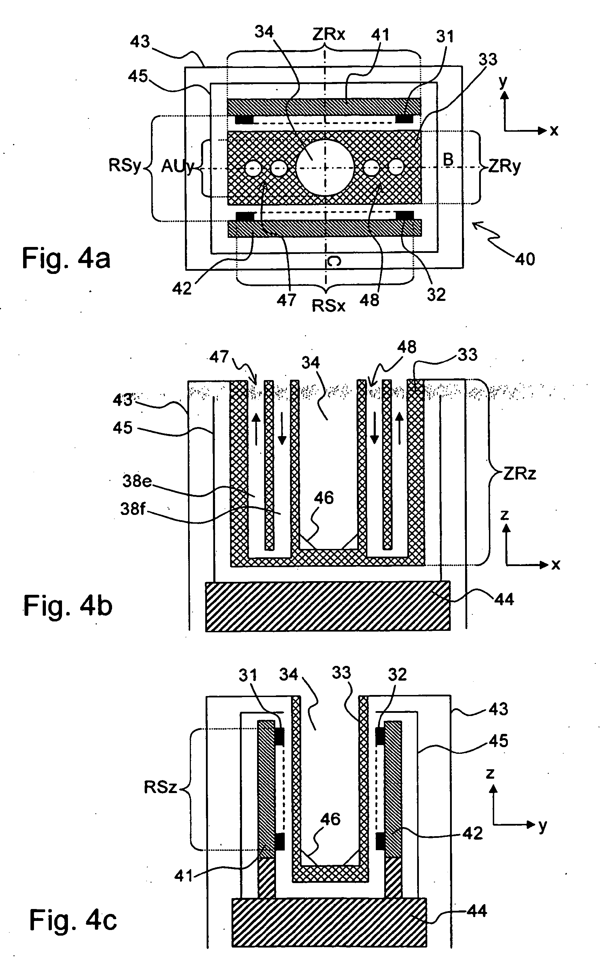

In der **Figur 3** ist eine Querschnittsansicht eines erfindungsgemäßen Probenkopfs senkrecht zur z-Achse gezeigt. Zwischen zwei planaren, parallelen HF-Resonatorspulen 31, 32 (die auf planaren Substraten 41, 42 angeordnet sind) ist ein im Wesentlichen quaderförmiger Zentralrohrblock 33 angeordnet. Der Zentralrohrblock 33 begrenzt gleichzeitig einen Vakuumbehälter, in dem die HF-Resonatorspulen 31, 32 angeordnet sind (weitere Begrenzungen des Vakuumbehälters sind nicht eingezeichnet, siehe dazu aber Fig. 4a-4c). Im Zentrum des Zentralrohrblocks 33 ist eine kreiszylindrische Ausnehmung 34 vorgesehen, in der eine Messprobe 35 angeordnet ist. Die HF-Resonatorspulen 31, 32 überspannen in der xy-Ebene auf beiden Seite der Messprobe 35 einen Winkelbereich von je ca. 120° um das Zentrum der Messprobe 35.

Die Messprobe 35 umfasst ein Probengefäß 36 mit einem Innenraum, in dem eine Probensubstanz 37 angeordnet ist. Im Zentralrohrblock 33 ist eine Kühlmittelführung vorgesehen, von der in Fig. 3d zwei Führungsabschnitte 38a, 38b zu sehen sind. In der Kühlmittelführung strömt ein Kühlmittel, durch das der Zentralrohrblock 33 temperiert wird. Durch die Temperierung des Zentralrohrblocks 33 kommt es auch zu einer Temperierung der Messprobe 35, die unmittelbar an der Wand der Ausnehmung 34 (und damit am Zentralrohrblock 33) anliegt. Zwischen dem Zentralrohrblock 33 und den HF-Resonatorspulen 31, 32 verbleibt ein kleiner lsolationsspalt 39 zur thermischen Isolation der HF-Resonatorspulen 31, 32.

Bei gleicher Größe der Messprobe kann bei den erfindungsgemäßen Probenköpfen die Gesamtheit der HF-Resonatorspulen 31, 32 kompakter ausgeführt werden als bei den Probenköpfen von Fig. 2. Insbesondere können bei den erfindungsgemäßen Probenköpfen die HF-Resonatorspulen 31, 32 in y-Richtung näher an die Messprobe 33 heranrücken, da ein Temperierungsspalt erfindungsgemäß unnötig ist. Bei gleicher Winkelabdeckung können die HF-Resonatorspulen 31, 32 auch bezüglich der Länge in x-Richtung kürzer gebaut werden, wodurch das Spulenvolumen ebenfalls verringert ist.

Durch den massiveren Aufbau des Zentralrohrblocks 33 in Richtung der großen Achse (in der Ausführungsform von Fig. 3 parallel der x-Richtung) kann die minimale Wandstärke bei kleinen Probendurchmessern im Verhältnis zu zylinderförmigen Rohren weiter reduziert werden, ohne die mechanischen Eigenschaften des Zentralrohrblockes zu gefährden. Die HF-Resonatorspulen 31, 32 können weiter in y-Richtung an die Messprobe heranrücken. Dies führt zu einem weiteren Gewinn an Spuleneffizienz.

Darüber hinaus kann die Effizienz noch gesteigert werden, wenn analog zum Stand der Technik der Öffnungswinkel der planaren Resonatoren von 120° abweicht, insbesondere kleiner ausgeführt wird. Dies fällt allerdings eventuell zu Lasten der HF-Feldhomogenität in der Messprobe aus, so dass ein sinnvoller Kompromiss gefunden werden muss.

Zugleich kann ein weiteres Problem kleiner Messproben gelöst werden: Insbesondere weniger als 3 mm durchmessende Messproben haben extrem geringe Wandstärken der Probenbehälter und sind sehr fragil. Daher ist es wünschenswert, dass sich diese Messproben selbst im Probenkopf zentrieren und nicht mittels Spinner eingelassen werden, wie das gängige Lösung für größere Messproben ist. Auf diese Weise kann der Bruch der Messproben vermieden werden. Bedingt durch das geringe Gewicht dieser Messproben fällt es aber mit abnehmendem Durchmesser zunehmend schwerer, deren gleichmäßige Temperierung mittels eines Gasstromes zu gewährleisten, da die Messproben die Tendenz zum Aufschwimmen oder zumindest zu Vibrationen im Gasstrom haben, welche zu Artefakten in den Messungen führen. Wird die Messprobe mittels Spinner eingelassen, dann vervielfacht sich das Gewicht, da der Spinner ein deutlich höheres Gewicht aufweist als die Messproben. In diesem Fall können ausreichend hohe Strömungsgeschwindigkeiten des Gasstromes realisiert werden um Temperaturgradienten vorzubeugen ohne dass die Messproben aufschwimmen.

Bei der vorliegenden Erfindung können die Temperierung und die Messprobe räumlich voneinander getrennt werden, insbesondere wenn der Zentralrohrblock aus einem Material gefertigt wird, das eine hohe Wärmeleitung aufweist (Aluminiumoxyd (Al₂O₃), Aluminiumnitrid (AIN), Berylliumoxyd (BeO), Bornitrid (BN), Magnesiumoxyd (MgO), usw. oder Werkstoffe, die diese Materialien enthalten, insbesondere spanbearbeitbare Keramiken wie Shapal). Weiterhin kann anstelle eines Gasstromes auch mit einer Flüssigkeit temperiert werden, die eine deutlich höhere Wärmekapazität aufweist.

Die zentrale Bohrung (Ausnehmung) kann entweder als Sackloch ausgeführt werden oder mittels eines Stopfens verschlossen werden, dessen magnetische Suszeptibilität an die der Messprobe angepasst sein kann. Wird die zentrale Bohrung durchgehend ausgeführt, so können auch lediglich Führungen für das Probengläschen montiert werden, die dessen Position lateral sowie horizontal definieren. Alternativ kann das Probengläschen außerhalb (oberhalb) des Zentralrohres geführt und in der Höhe positioniert werden.

Die Temperierung des Samples erfolgt durch Wärmekontakt und/oder Wärmestrahlung. Bei geringem Probendurchmesser (3 mm und kleiner) ist die während der Sendephase in der Probe deponierte Leistung auch bei stark verlustbehafteten Messproben so gering, dass eine Temperierung durch Wärmestrahlung ausreichend ist. Bei größeren Messproben (> 5 mm) kann die in der Sendephase in die Messprobe eingestrahlte Heizleistung problematisch werden und eine zusätzliche Temperierung mittels Gasfluss kann angebracht sein.

Ein bekanntes Problem bei der hochauflösenden NMR ist, dass ein Temperaturgradient in den Messproben zu Artefakten in den Spektren führt (Linienverbreiterungen etc.). Wird der Zentralrohrblock aus einem Material mit hoher Wärmeleitfähigkeit gefertigt, so kann dieses Problem auf ein Minimum reduziert werden. Zudem sind die Artefakte in den Spektren von der absoluten Temperaturdifferenz abhängig und nicht von Gradienten. Bei geringen Probendurchmessern sind diese absoluten Temperaturabweichungen (zumindest die lateralen) vernachlässigbar.

Werden die Kühlmittelführungen von der Messprobe getrennt ausgeführt, dann kann der Kühlmittelfluss so erhöht werden, dass auch die Temperaturgradienten in der z-Richtung eliminiert werden. Ebenfalls hilfreich ist hierbei eine Umkehrung der Strömungsrichtung durch mehrerer Kühlmittelführungen, die zu einer gleichmäßigen Temperatur des Zentralrohrblocks in der z-Richtung führen.

Die Temperierung kann durch ein Thermometer kontrolliert und geregelt werden, das entweder auf dem Zentralrohrblock in der Nähe der Messprobe befestigt werden kann oder aber auch lediglich die Temperatur des Kühlmittels misst. Im zweiten Falle kann das Thermometer z.B. außerhalb des Messbereiches im Kühlmittelstrom montiert werden. Die zur Temperierung notwendige Wärmequelle oder -senke (Heizung/Kühlung) kann außerhalb oder innerhalb des Vakuumbehälters montiert werden und über das Thermometer und eine Steuerung, z.B. ein PID-Steuerungselement geregelt werden.

### Ausführungsformen der Figuren

Die **Figuren 4a-4c** zeigen einen erfindungsgemäßen Probenkopf 40 in verschiedenen schematischen Schnittdarstellungen. Fig. 4a zeigt einen Schnitt durch die xy-Ebene, wobei in z-Richtung senkrecht zur Zeichenebene in einer NMR-Apparatur ein starkes Magnetfeld B₀ angelegt wird. Fig. 4b zeigt einen Schnitt entlang Line B in Fig. 4a, und Fig. 4c einen Schnitt entlang Linie C in Fig. 4a.

Der Probenkopf 40 weist einen Vakuumbehälter 43 auf, in dem schematisch zwei planare HF-Resonatorspulen 31, 32 aus HTS-Material im Vakuum angeordnet sind. Mit gestrichelten Linien ist der weitere Verlauf von Leiterabschnitten der Resonatorspulen 31, 32 oberhalb bzw. unterhalb der Zeichenebenen dargestellt. Die HF-Resonatorspulen 31, 32 sind auf ebenen Substraten 41, 42 angeordnet, die ihrerseits an einer gekühlten Plattform 44 befestigt sind. Durch die gekühlte Plattform 44 werden die HF-Resonatorspulen 31, 32 auf eine Temperatur unterhalb der Sprungtemperatur des HTS-Materials gekühlt. Ein Strahlungsschild 45 vermindert den Eintrag von Wärmestrahlung auf die HF-Resonatorspulen 31, 32 und die ebenen Substrate 41, 42.

Die HF-Resonatorspulen 31, 32 weisen als Gesamtheit in x-Richtung eine Erstreckung RSx, in y-Richtung eine Erstreckung RSy, und in z-Richtung eine Erstreckung RSz auf. Durch diese Erstreckungen wird auch ein Spulenraum oder Raum zwischen den HF-Resonatorspulen 31, 32 festgelegt. Dabei ist RSx deutlich größer als RSy.

Der Vakuumbehälter 43 wird in seinem Zentrum durch einen Zentralrohrblock 33 begrenzt. Der Zentralrohrblock 33 weist eine Ausnehmung 34 auf, in die die Messprobe (nicht dargestellt) eingeführt werden kann. Typischerweise entspricht der Außendurchmesser der Messprobe dem Durchmesser der Ausnehmung 34, so dass die Messprobe an der Ausnehmung 34 anliegt. In der Ausnehmung 34 sind Zentrierelemente 46 vorgesehen, die die Messprobe selbsttätig ausrichten. In einer alternativen Ausführungsform (nicht dargestellt) kann die Ausnehmung auch so gestaltet sein, dass sie rohrförmig den gesamten Probenkopf von oben bis unten durchdringt.

Der Zentralrohrblock 33 hat Erstreckungen in x- y- und z-Richtung von ZRx, ZRy, ZRz. Dabei ist ZRx deutlich größer als ZRy. Durch diese in x-Richtung langgestreckte Form können in x-Richtung seitlich der Ausnehmung 34 Kühlmittelführungen 47, 48 im Zentralrohrblock 33 ausgebildet werden, ohne dass dadurch ein größerer Abstand der beiden HF-Resonatorspulen 31, 32 erforderlich wäre. Dies ist insbesondere dadurch gewährleistet, dass die Kühlmittelführungen 47, 48 sich in y-Richtung vollständig innerhalb der y-Erstreckung AUy der Ausnehmung 34 erstrecken; AUy entspricht dabei der y-Erstreckung einer nicht eingezeichneten, in der Ausnehmung 34 anliegenden Messprobe. Durch die Kühlmittelführungen 47, 48 fließt im Messbetrieb ein Kühlmittel (vgl. Pfeile in Fig. 4b), welches den Zentralrohrblock 33 temperiert. Der Zentralrohrblock 33 wiederum temperiert eine in der Ausnehmung 34 angeordnete Messprobe. Die Kühlmittelführungen 47, 48 weisen dabei mehrere Führungsabschnitte (etwa 38e, 38f) auf, zwischen denen sich die Flussrichtung des Kühlmittels ändert.

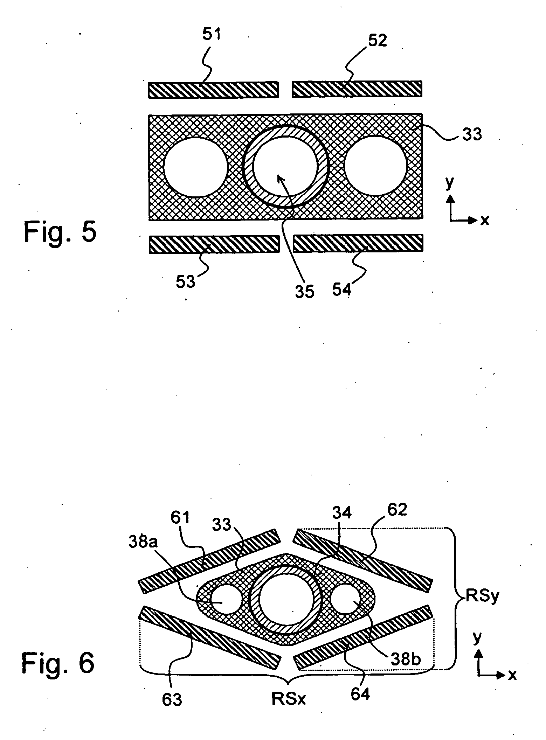

Die **Figur 5** illustriert einen erfindungsgemäßen Magnetresonanz-Probenkopf in schematischem Querschnitt in der xy-Ebene, bei dem insgesamt vier planare HF-Resonatorspulen 51, 52, 53, 54 um einen Zentralrohrblock 33 angeordnet sind. Die HF-Resonatorspulen 51-54 sind dabei alle parallel einer xz-Ebene angeordnet. Der Rest des Vakuumbehälters ist zur Vereinfachung nicht dargestellt.

**Figur 6** zeigt ebenfalls einen erfindungsgemäßen NMR-Probenkopf mit vier planaren HF-Resonatorspulen 61-64 in schematischer Querschnittsdarstellung, wobei allerdings die Spulen 61 und 63 ein zum Zentralrohrblock 33 offenes V bilden, ebenso wie die Spulen 62 und 64. Es gilt, dass RSx ist deutlich größer als RSy ist, und bei einer runden Messprobe mit in x- und y-Richtung kleinem Durchmesser verbleibt dann links und rechts (in x-Richtung neben) der Ausnehmung 34 genügend Platz für Kühlmittelführungen bzw. deren Führungselemente 38a, 38b.

Im Folgenden sollen weitere Formen von Zentralrohrblöcken, die im Rahmen der Erfindung eingesetzt werden können, erläutert werden.

Die einfachste Ausführungsform eines Zentralrohrblocks 33 besteht aus einem quaderförmigen Stück dielektrischen Materials mit hoher Wärmeleitfähigkeit (z.B. Saphir, amorphes Aluminiumoxyd, Aluminiumnitrid, Berylliumoxyd, Bornitrid, Magnesiumoxyd, Shapal, ...), das mit drei Löchern versehen wird, wobei das zentrale Loch die Messprobe aufnimmt und die lateralen Löcher für die Temperierung einzusetzen sind, vgl. Zentralrohrblock 33 in **Fig. 7**. Das dielektrische Material sollte möglichst geringe HF-Verluste aufweisen (elektrische Leitfähigkeit σ < 10⁻⁵ S/m, insbesondere möglichst< 10⁻⁸ S/m und Verlustfaktor tan δ < 10⁻³, insbesondere möglichst < 10⁻⁵), damit die HF-Verluste des Zentralrohrblocks nicht die Empfindlichkeit des Probenkopfes reduzieren.

Wird der Querschnitt des Zentralrohrblocks nicht rechteckig, sondern zumindest abschnittweise oval oder elliptisch ausgeführt, vgl. Zentralrohrblock 81 in **Fig. 8**, so ist es bedeutend einfacher, eine Vakuumdichtung z.B. mittels O-Ring, Indium, etc. herzustellen.

Der Zentralrohrblock kann auch aus zwei Platten oder Halbschalen 91, 92 hergestellt werden, in die jeweils drei (oder mehr) Rillen für eine Ausnehmung 34 und Führungsabschnitte 38c, 38d einer Kühlmittelführung gefräst/poliert werden, vgl. **Figuren 9 und 10**. Im Anschluss können die beiden Platten 91, 92 verklebt/verlötet werden. Hierbei bieten sich anorganische Klebstoffe sowie Glaslot an, insbesondere wenn der NMR-Probenkopf zur Detektion von Protonen und Carbon-Signalen eingesetzt werden soll. Um keine Störungen des statischen Magnetfeldes durch inhomogenen Klebstoffauftrag zu erzeugen, ist es sinnvoll, eine Klebefuge vorzusehen und nach Klebung/Lötung das überschüssige Material abzuschleifen. Es besteht auch die Möglichkeit, den Zentralrohrblock aus Platten und Quadern zusammenzusetzen. Allerdings hat diese Methode den Nachteil, dass bedeutend mehr Verbindungsstellen existieren, die vakuumdicht sein müssen und keine Störungen des statischen Feldes verursachen dürfen. Die Rillen können auch geätzt statt poliert werden. Dies bietet sich insbesondere bei einer Herstellung aus Glas an. Glasplatten können im Anschluss unter Aufwendung von Druck und Temperatur miteinander verschmolzen werden, ohne Klebstoffe anwenden zu müssen.

Allerdings ist die Wärmeleitfähigkeit von Glas relativ gering, weshalb bei Verwendung dieses Materials eine zusätzliche Temperierung mittels Gasfluss wünschenswert ist.

Bei einer anderen Ausführungsform, bei der das Sample nicht vom Temperiergas getrennt wird, ist der Zentralrohrblock 111 bei im Wesentlichen konstanter Wandstärke oval/elliptisch ausgeführt, vgl. **Fig. 11**, oder die Löcher im Zentralrohrblock 121 sind so angeordnet, dass sie sich partiell überlappen, vgl. **Fig. 12**. Erstere Form kann besonders einfach aus formbaren Materialien wie Glas oder Kunststoff hergestellt werden, die zweite kann auch aus Hartstoffen geschliffen werden. Der Vorteil der zweiten Ausführungsform ist, dass das Probenröhrchen gleichsam geführt und zentriert wird sowie die Temperierung durch Wärmeleitung, Strahlung und Gasfluss erzielt wird. Die Ausnehmung 112 bzw. 122 umfasst Raum für die Messprobe und die Kühlmittelführung. Nachteilig wirkt sich bei diesen Ausführungsformen aus, dass die Messproben eventuell durch den Gasfluss aufschwimmen können.

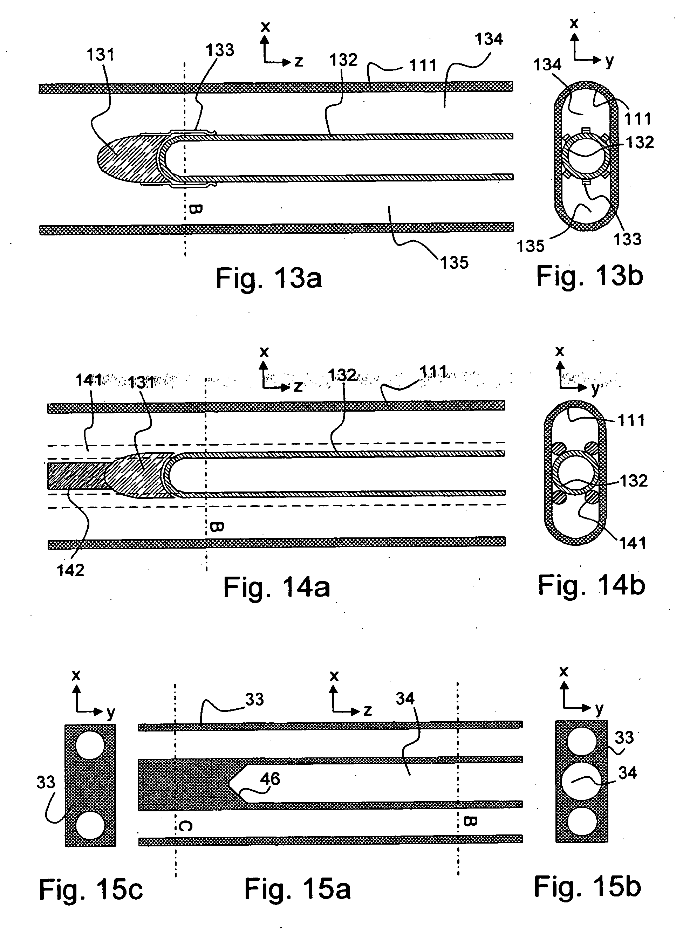

Wird die ovale Ausführungsform von Fig. 11 verwendet, so ist eine Führung und ein Anschlag des Probengläschens notwendig. Diese kann einerseits einen Verdrängungskörper 131 beinhalten, der den Staudruck des Gases vom Probenbehälter (Probengläschen) 132 fernhält, vgl. **Fig. 13a, 13b**, und andererseits auch Führungen 133, 141, die das Probengläschen 132 zentrieren, vgl. auch **Fig. 14a, 14b**. Die Figuren 13b, 14b zeigen jeweils den Querschnitt entlang Linie B in Fig. 13a, 14a. Der Verdrängungskörper 131 kann so ausgeführt werden, dass er die Suszeptibilität des Probengläschens 132 (gefüllt mit einem gängigen bzw. verwendeten Lösungsmittel, z.B. Wasser) weitestgehend reproduziert. Dadurch können die magnetischen Störungen limitiert werden, die vom Sprung der Suszeptibilität am Ende des Probengläschens 132 herrühren. Der Verdrängungskörper 131 kann entweder am Zentralrohrblock 111 befestigt werden, oder zur Befestigung mittels einer Verlängerung 142 nach unten geführt werden, vgl. Fig. 14a. Die Führungen 133 werden am besten aus einem Material mit leichter Federkraft und an das Umgebungsmedium (Luft, Stickstoff, ...) angepasster magnetischer Suszeptibilität hergestellt, um Störungen des statischen Magnetfeldes zu vermeiden. Alternativ können die Führungen 141 auch als durchgehende Stangen ausgeführt werden und deutlich länger sein als das Messvolumen hoch ist (hoch in z-Richtung). Dadurch erübrigen sich die Anforderungen an die Suszeptibilität des Materials.

Weiterhin kann der Gasstrom von oben statt von unten erfolgen, so dass das Probengläschen nicht durch den Gasstrom aus dem Probenkopf geblasen werden kann, sondern gegen den Anschlag gedrückt wird.

Man beachte, dass in der Ausführungsform von Fig. 13a, 13b die Kühlmittelführungen 134, 135 unmittelbar durch das Probengefäß 132 mit begrenzt werden.

Die zentrale Bohrung (Ausnehmung) kann mit einem Stopfen verschlossen werden oder als Sackloch ausgeführt werden. Auf diese Weise wird das Probenröhrchen in der Höhe positioniert. **Fig. 15a** zeigt einen Zentralrohrblock 33 mit einer als Sackloch ausgebildeten Ausnehmung 34, **Fig. 15b und 15c** zeigen jeweils den Querschnitt entlang den Linien B und C in Fig. 15a.

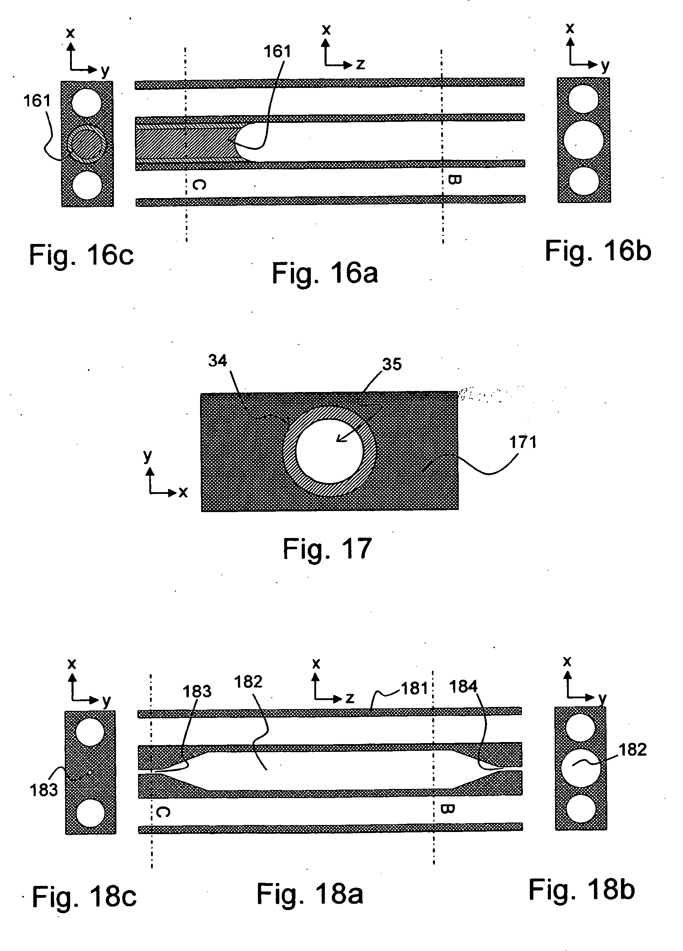

Wird ein Stopfen 161 verwendet, vgl. **Fig. 16a**, so kann dieser aus einem Material ausgeführt werden, dessen Suszeptibilität nahe an der des Probengläschens (nicht eingezeichnet) mit einem gängigen Lösungsmittel ist. Auf diese Weise kann die Störung des statischen Magnetfeldes am Ende der Messprobe verringert werden. Dies hilft auch die für das Shimen notwendige Füllhöhe der Messprobe zu reduzieren. Es ist auch möglich, den Stopfen 161 zwei- oder mehrteilig auszuführen, so dass das Probengläschen und die Probensubstanz separat "magnetisch verlängert" werden. In diesem Fall resultiert lediglich eine Störung durch die Präsenz des Bodens des Probengläschens. **Fig. 16b und 16c** zeigen jeweils den Querschnitt entlang den Linien B und C in Fig. 16a.

Zur Kompensation der Suszeptibilität des Stopfens 161 kann dieser auch aus einem Material mit höherer Suszeptibilität als die Messsubstanz (z. B. Glas) und mit einer Bohrung ausgeführt werden, die so gestaltet ist, dass die globale Suszeptibilität derjenigen der Messprobe angenähert ist.

Es besteht auch die Möglichkeit, in den Zentralrohrblock 171 lediglich die Bohrung (Ausnehmung 34) zur Aufnahme der Messprobe 35 einzuarbeiten und den Rest möglichst massiv auszuführen, vgl. **Fig. 17****.** In diesem Fall kann die Temperierung mittels eines elektrischen Heizers ausgeführt werden, der unterhalb und/oder oberhalb des Messbereiches auf dem Zentralrohrblock 171 aufgebracht wird. Die Wärmeleitung des Zentralrohrblocks 171 wird durch das zusätzliche Material in x-Richtung seitlich verbessert, was zu geringeren Temperaturgradienten über den Messbereich hinweg führt. Diese Lösung erlaubt keine aktive Kühlung der Messprobe 35. Die Wärmestrahlung zu den Sende-/Empfangsspulen (nicht eingezeichnet), die den Zentralrohrblock 171 umgeben, muss zur Kühlung verwendet werden. Dadurch werden die Regulierungszeiten langsamer und der einstellbare Temperaturbereich ist begrenzt.

Zur Temperierung kann im Rahmen der Erfindung statt Gasfluss auch Flüssigkeitsfluss eingesetzt werden. Es ist hierbei darauf zu achten, dass die Flüssigkeit geringe elektromagnetische Verluste aufweist. Weiterhin darf sie keine Kerne enthalten, die störende NMR-Signale erzeugen können. In der hochauflösenden NMR-Spektroskopie sind insbesondere ¹H, ²H, ¹³C, ¹⁵N, ¹⁹F, und ³¹P wichtige Messkerne, aber auch alle anderen Kerne mit Spin ungleich null und einem gyromagnetischen Verhältnis γ im Bereich 10⁷ rad T⁻¹ s⁻¹ < γ < 3.10⁸ rad T⁻¹ s⁻¹. Die Dielektrizitätskonstante sollte weiterhin so gering wie möglich sein, damit sich bei Dichtefluktuationen die Resonanzfrequenz der Resonatoren möglichst wenig verändert. Daher sind nichtpolare Lösungsmittel besser geeignet als polare Lösungsmittel. Insbesondere Wasser ist bei hohen Frequenzen stark verlustbehaftet, so dass es nur dann sinnvoll eingesetzt werden kann, wenn es vom elektrischen Feld der Spule abgeschirmt wird. Besser noch wird die Kühlflüssigkeit auch vom magnetischen Feld abgeschirmt, außer es werden z.B. deuterierte Lösungsmittel bzw. fluorierte oder chlorierte Lösungsmittel eingesetzt. In diesem Fall kann die Temperierflüssigkeit auch als externe Locksubstanz eingesetzt werden.

Bei Verwendung mehrerer Bohrungen im Zentralrohrblock kann der Gas/Flüssigkeitsfluss anstatt geradlinig durch eine Kühlmittelführung zu fließen auch ein- oder mehrfach die Richtung wechseln. Auf diese Weise können Temperaturgradienten in z-Richtung in der Messprobe verringert werden.

Der Zentralrohrblock 181 kann auch so ausgeführt werden, dass er eine Flusszelle 182 als Ausnehmung beinhaltet, d.h. dass die Sampleflüssigkeit mittels Ein- und Auslass 183, 184 direkt in eine Kammer des Zentralrohrblocks 181 gefüllt wird, siehe **Fig. 18a. Fig. 18b und 18c** zeigen jeweils den Querschnitt entlang den Linien B und C in Fig. 18a. Ein- und Auslass 183, 184 sind normalerweise dergestalt geformt, dass die Bildung von Bläschen vermieden wird. Hierzu kann die Verwendung von zusätzlichen Strömungselementen notwendig sein, die den Fluss der Sampleflüssigkeit beeinflussen. Weiterhin wird in der Regel der Zu- und Abfluss 183, 184 dergestalt ausgeführt, dass sie möglichst kleine Durchmesser haben. Dies reduziert das Volumen der Flüssigkeit außerhalb des Messvolumens.

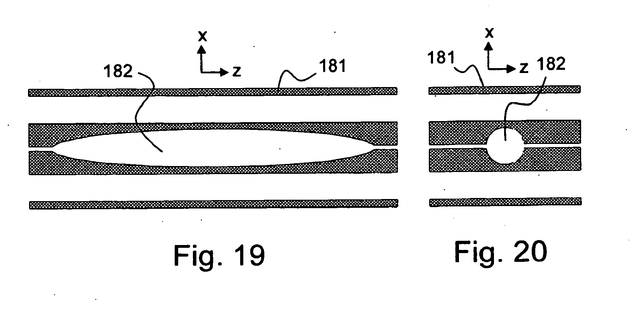

Das Messvolumen, d.h. die Flusszelle 182, kann in einer beliebigen Form ausgestaltet sein, sowohl im Querschnitt als auch im Längsschnitt. Besonders nützliche Formen sind verallgemeinerte Ellipsoide wie Kugel (vgl. **Fig. 20**), Ellipsoid (vgl. **Fig. 19**), oder unendlich lange Zylinder mit kreisförmigen, elliptischen, ovalen oder rechteckigen Querschnitten. Unendlich lang bedeutet hier, dass das HF-Feld des Messkopfes am Ende des Zylinders auf 1/10, besser 1/100 seiner maximalen Stärke im Messvolumen abgefallen sein soll.

Zur Reduktion der Wärmelast kann der Zentralrohrblock im Rahmen der Erfindung mit einer Schicht beschichtet werden, die die Wärmestrahlung reflektiert. Die Schicht kann strukturiert werden, um deren Hochfrequenzeigenschaften zu verbessern. Alternativ können auch Fasern wie in Ref. [2] ausgeführt montiert werden. Ist die Schicht elektrisch leitfähig, so kann sie auch als elektrischer Heizer für den Zentralrohrblock genutzt werden.

### Referenzen

[1] Kunihiko US 3 525 928 (A)
[2] Marek: DE 10 006 324
[3] Marek: US 5 247 256
[4a] Black and Roemer: US 5 258 710
[4b] Kotsubo and Black: US 5 508 613
[5] Withers: US 5 585 723
[6] Hofmann et al.: US 6 838 880 (B2)
[7] Hasegawa et al.: US 6 914 430
[8] Swiet: US 2005 077 900

## Patentansprüche

1. Magnetresonanz-Probenkopf (40), umfassend
- einen Vakuumbehälter (43), in welchem mehrere, kryogen kühlbare HF-Resonatorspulen (31, 32; 51-54, 61-64) angeordnet sind,
wobei die Gesamtheit der HF-Resonatorspulen (31, 32; 51-54, 61-64) eine größere Erstreckung in einer x-Richtung (RSx) als in einer y-Richtung (RSy) aufweist,
wobei die Gesamtheit der HF-Resonatorspulen (31, 32; 51-54, 61-64) spiegelsymmetrisch bezüglich einer xz-Ebene angeordnet ist, und
wobei die Richtungen x, y, z ein rechtwinkliges Koordinatensystem bilden,
**dadurch gekennzeichnet, dass** der Probenkopf
einen zwischen den HF-Resonatorspulen (31, 32; 51-54, 61-64) angeordneten Zentralrohrblock (33; 81; 111; 121; 171; 181) umfasst, der eine in z-Richtung langgestreckte Ausnehmung (34; 112; 122) für eine Messprobe (35) aufweist, wobei die Gesamtheit der HF-Resonatorspulen (31, 32; 51-54, 61-64) symmetrisch um die Ausnehmung (34; 112; 122) für die Messprobe (35) angeordnet ist,
wobei der Zentralrohrblock (33; 81; 111; 121; 171; 181) den Vakuumbehälter (43) teilweise begrenzt und die der Ausnehmung (34; 112; 122) zugewandte Wand des Vakuumbehälters (43) bildet, wobei die Ausnehmung (34; 112; 122) außerhalb des Vakuumbehälters (43) liegt,
wobei der Zentralrohrblock (33; 81; 111; 121; 171; 181) für eine Temperierung der Messprobe (35) in der Ausnehmung (34; 112; 122) ausgebildet und im Bereich zwischen den HF-Resonatorspulen (31, 32; 51-54, 61-64) eine größere Erstreckung in der x-Richtung (ZRx) als in der y-Richtung (ZRy) aufweist, und
wobei jede der HF-Resonatorspulen auf einem ebenen Substrat angeordnet und als Planarspule ausgebildet ist, welche parallel zur z-Richtung liegt.

2. Magnetresonanz-Probenkopf (40) nach Anspruch 1, **dadurch gekennzeichnet, dass** in der Ausnehmung (34; 112; 122) für eine Messprobe (35) eine Messprobe (35) angeordnet ist, insbesondere wobei die Messprobe (35) einen kreisrunden Querschnitt bezüglich der xy-Ebene hat.

3. Magnetresonanz-Probenkopf (40) nach Anspruch 2, **dadurch gekennzeichnet, dass** die Messprobe (35) in der xy-Ebene einen maximalen Durchmesser von 3 mm oder weniger aufweist.

4. Magnetresonanz-Probenkopf (40) nach Anspruch 2 oder 3, **dadurch gekennzeichnet, dass** der Durchmesser der Messprobe (35) in y-Richtung gleich ist dem Durchmesser (AUy) der Ausnehmung (34; 112; 122) in y-Richtung.

5. Magnetresonanz-Probenkopf (40) nach einem der vorhergehenden Ansprüche, **dadurch gekennzeichnet,**
**dass** zwei HF-Resonatorspulen (31, 32; 51-54) vorgesehen sind, die jeweils als Planarspulen in einer xz-Ebene ausgebildet sind,
und **dass** die zwei HF-Resonatorspulen (31, 32; 51-54) in y-Richtung beabstandet sind und einander gegenüberliegen.

6. Magnetresonanz-Probenkopf (40) nach Anspruch 5, **dadurch gekennzeichnet, dass** der Zentralrohrblock (33; 81; 111; 121; 171; 181) zwei den zwei HF-Resonatorspulen (31, 32; 51-54) zugewandte ebene Außenflächen aufweist, die jeweils in einer xz-Ebene liegen.

7. Magnetresonanz-Probenkopf (40) nach einem der vorhergehenden Ansprüche, **dadurch gekennzeichnet, dass** die Gesamtheit der HF-Resonatorspulen (31, 32; 51-54, 61-64) spiegelsymmetrisch bezüglich einer yz-Ebene angeordnet ist.

8. Magnetresonanz-Probenkopf (40) nach einem der vorhergehenden Ansprüche, **dadurch gekennzeichnet, dass** vier planare HF-Resonatorspulen (61-64) vorgesehen sind, die im Querschnitt bezüglich der xy-Ebene die Gestalt zweier mit ihren offenen Seiten aufeinander zu gerichteter "V"s aufweisen.

9. Magnetresonanz-Probenkopf (40) nach einem der vorhergehenden Ansprüche, **dadurch gekennzeichnet, dass** der Zentralrohrblock (81; 111) in der xy-Ebene einen abgerundeten Außenquerschnitt zum Vakuumbehälter (43) aufweist,
insbesondere wobei der Außenquerschnitt vollständig oder abschnittsweise elliptisch oder oval ausgebildet ist.

10. Magnetresonanz-Probenkopf (40) nach einem der vorhergehenden Ansprüche, **dadurch gekennzeichnet, dass** der Zentralrohrblock (33; 81; 111; 121; 171; 181) aus einem Material mit einer Wärmeleitfähigkeit ≥ 5 W/(m*K), insbesondere aus Saphir, amorphem Aluminiumoxyd, Aluminiumnitrid, Bornitrid, Berylliumoxyd, Magnesiumoxyd oder Werkstoffen, die diese Materialien enthalten, insbesondere spanbearbeitbare Keramiken wie Shapal besteht.

11. Magnetresonanz-Probenkopf (40) nach einem der vorhergehenden Ansprüche, **dadurch gekennzeichnet**, derZentralrohrblock (33; 81; 111; 121; 171; 181) zwei mit Rillen versehenen Halbschalen (91, 92) aufweist, die in einer xz-Ebene aneinander befestigt, insbesondere miteinander verklebt, verschmolzen oder verlötet, sind.

12. Magnetresonanz-Probenkopf (40) nach einem der vorhergehenden Ansprüche, **dadurch gekennzeichnet, dass** der Zentralrohrblock (33; 81; 111; 121; 171; 181) eine elektrisch leitfähige Beschichtung aufweist.

13. Magnetresonanz-Probenkopf (40) nach einem der vorhergehenden Ansprüche, **dadurch gekennzeichnet, dass** der Zentralrohrblock (33; 81; 111; 121; 171; 181) mit elektrisch nichtleitenden Fasern umgeben ist.

14. Magnetresonanz-Probenkopf (40) nach einem der vorhergehenden Ansprüche, **dadurch gekennzeichnet, dass** im Zentralrohrblock (33; 81; 111; 121; 181) mindestens eine Kühlmittelführung (47, 48; 134, 135) vorgesehen ist,
dass in der Ausnehmung (34; 112; 122) für eine Messprobe (35) eine Messprobe (35) angeordnet ist,
dass im Bereich zwischen den HF-Resonatorspulen (31, 32; 51-54; 61-64) die mindestens eine Kühlmittelführung (47, 48; 134, 135) seitlich der Messprobe (35) in Hinblick auf die x-Richtung verläuft,
und dass sich im Bereich zwischen den HF-Resonatorspulen (31, 32; 51-54; 61-64) die mindestens eine Kühlmittelführung (47, 48; 134, 135) in y-Richtung vollständig innerhalb des Bereichs der y-Erstreckung der Messprobe (35) befindet.

15. Magnetresonanz-Probenkopf (40) nach Anspruch 14, **dadurch gekennzeichnet, dass** die mindestens eine Kühlmittelführung (47, 48; 134, 135) im Bereich zwischen den HF-Resonatorspulen (31, 32; 51-54; 61-64) zwei Führungsabschnitte (38a-38f) aufweist, die bezüglich der x-Richtung zu beiden Seiten der Messprobe (35) verlaufen.

16. Magnetresonanz-Probenkopf (40) nach Anspruch 14 oder 15, **dadurch gekennzeichnet, dass** die mindestens eine Kühlmittelführung (47, 48; 134, 135) eine Mehrzahl von aufeinanderfolgenden Führungsabschnitten (38a-38f), insbesondere wenigstens vier aufeinanderfolgende Führungsabschnitte, aufweist, zwischen denen sich jeweils die Verlaufsrichtung der Kühlmittelführung (47, 48, 134, 135) ändert.

17. Magnetresonanz-Probenkopf (40) nach einem der Ansprüche 14 bis 16, **dadurch gekennzeichnet, dass** die mindestens eine Kühlmittelführung (47, 48) von der Ausnehmung (34) für die Messprobe (35) separat ist.

18. Magnetresonanz-Probenkopf (40) nach Anspruch 17, **dadurch gekennzeichnet,**
**dass** die Ausnehmung (34) für die Messprobe (35) als Flusszelle (182) ausgebildet ist,
insbesondere wobei die Ausnehmung (34) mit einer fließfähigen Probensubstanz als Messprobe (35) unmittelbar gefüllt ist.

19. Magnetresonanz-Probenkopf (40) nach Anspruch 18, **dadurch gekennzeichnet, dass** die Flusszelle (182) als Rotationsellipsoid mit einer Rotationsachse parallel zur z-Richtung ausgebildet ist.

20. Magnetresonanz-Probenkopf (40) nach einem der Ansprüche 18 oder 19, **dadurch gekennzeichnet, dass** die Flusszelle (182) sich zu ihren Zuführungen (183, 184) hin verengt.

21. Magnetresonanz-Probenkopf (40) nach Anspruch 17, **dadurch gekennzeichnet, dass** in der Ausnehmung (34) für eine Messprobe (35) eine Messprobe (35) angeordnet ist,
und dass die Messprobe (35) ein Probengefäß (36) umfasst, das mit einer Probensubstanz befüllt ist.

22. Magnetresonanz-Probenkopf (40) nach Anspruch 21, **dadurch gekennzeichnet, dass** das Probengefäß (36) zumindest im Bereich zwischen den HF-Resonatorspulen (31, 32; 51-54; 61-64) abschnittweise oder vollständig flächig an der Wand der Ausnehmung (34) des Zentralrohrblocks (33; 81; 171) anliegt.

23. Magnetresonanz-Probenkopf (40) nach einem der Ansprüche 21 oder 22, **dadurch gekennzeichnet,**
**dass** die Ausnehmung (34) als eine durchgehende Bohrung durch den Zentralrohrblock (33; 81; 171) ausgebildet ist,
**dass** die Bohrung einenends mit einem Stopfen (161) verschlossen ist, wobei das dem Probengefäß (36) zugewandte Ende des Stopfens (161) parallel dem dem Stopfen (161) zugewandten Ende des Probengefäßes (36) gekrümmt ist,
und **dass** die magnetische Suszeptibilität des Materials des Stopfens (161) der magnetischen Suszeptibilität der Messprobe (35) entspricht.

24. Magnetresonanz-Probenkopf (40) nach einem der Ansprüche 21 oder 22, **dadurch gekennzeichnet, dass** die Ausnehmung (34) als Sackloch im Zentralrohrblock (33; 81; 171) ausgebildet ist.

25. Magnetresonanz-Probenkopf (40) nach einem der Ansprüche 14 bis 16, **dadurch gekennzeichnet,**
**dass** die Ausnehmung (112; 122) für die Messprobe (35; 132) auch die mindestens eine Kühlmittelführung (134, 135) umfasst,
**dass** in der Ausnehmung (112, 122) für eine Messprobe (35) eine Messprobe (35) angeordnet ist,
**dass** die Messprobe (35) ein Probengefäß (132) umfasst, das eine Probensubstanz enthält,
und **dass** das Probengefäß (132) die mindestens eine Kühlmittelführung (134, 135) teilweise begrenzt.

26. Magnetresonanz-Probenkopf (40) nach Anspruch 25, **dadurch gekennzeichnet, dass** in der Ausnehmung Zentrierungselemente und/oder Anschlagselemente (133; 141) vorgesehen sind, die das Probengefäß (132) beim Einführen in die Ausnehmung (112, 122) in der xy-Ebene und/oder in z-Richtung positionieren.

27. Magnetresonanz-Probenkopf (40) nach Anspruch 26, **dadurch gekennzeichnet, dass** die Zentrierungselemente und/oder Anschlagelemente (133; 141) aus einem Material mit magnetischer Suszeptibilität entsprechend der Volumensuszeptibilität eines Kühlmittels der Kühlmittelführung (134, 135) hergestellt sind,
insbesondere wobei in der Kühlmittelführung (134, 135) Luft mit einer Volumensuszeptibilität von 0,4 ppm in SI-Einheiten oder Stickstoff mit einer Volumensuszeptibilität von -0,0064 ppm in SI-Einheiten vorgesehen ist.

28. Magnetresonanz-Probenkopf (40) nach einem der Ansprüche 25 bis 27, **dadurch gekennzeichnet, dass** der Zentralrohrblock (111) mindestens im Bereich des HF-Feldes der HF-Resonatorspulen (31; 51-54; 61-64) eine im Querschnitt bezüglich der xy-Ebene konstante Wandstärke aufweist.

29. Magnetresonanz-Probenkopf (40) nach einem der Ansprüche 21 bis 28, **dadurch gekennzeichnet, dass** die Ausnehmung (34; 112; 122) für die Messprobe (35; 132) im Wesentlichen zylinderförmig mit der Zylinderachse in z-Richtung ausgebildet ist.

30. NMR(Kernspinresonanz)-Messapparatur, umfassend ein Magnetsystem zur Erzeugung eines homogenen statischen Magnetfelds B₀ in z-Richtung und ein NMR-Spektrometer mit einen Magnetresonanz-Probenkopf (40) gemäß einem der vorhergehenden Ansprüche.

## Claims

1. Magnetic resonance probe head (40), comprising
- a vacuum container (43) in which several RF resonator coils (31, 32; 51-54, 61-64) are disposed which can be cryogenically cooled,
wherein the entirety of the RF resonator coils (31, 32; 51-54, 61-64) has a larger extension in an x direction (RSx) than in a y direction (RSy),
wherein the entirety of the RF resonator coils (31, 32; 51-54, 61-64) is arranged mirror-symmetrically with respect to a xz plane, and
wherein the directions x, y, z form a rectangular coordinate system, **characterized in that** the probe head
comprises a central tube block (33; 81; 111; 121; 171; 181) disposed between the RF resonator coils (31, 32; 51-54, 61-64), which has a recess (34; 112; 122), which is elongated in the z direction, for a test sample (35),
wherein the entirety of the RF resonator coils (31, 32; 51-54, 61-64) is disposed symmetrically around the recess (34; 112; 122) for the test sample (35),
wherein the central tube block (33; 81; 111; 121; 171; 181) partially delimits the vacuum container (43) and forms the wall of the vacuum container (43) facing the recess (34; 112; 122), wherein the recess (34; 112; 122) is outside of the vacuum container (43),
wherein the central tube block (33; 81; 111; 121; 171; 181) is designed for controlling the temperature of the test sample (35) in the recess (34; 112; 122) and has a larger extension in the x direction (ZRx) than in the y direction (ZRy) in the area between the RF resonator coils (31, 32; 51-54, 61-64), and
wherein each of the RF resonator coils is disposed on a flat substrate and is designed as planar coil which is parallel to the z direction.

2. Magnetic resonance probe head (40) according to claim 1, **characterized in that** a test sample (35) is disposed in the recess (34; 112; 122) for a test sample (35), in particular, wherein the test sample (35) has a circular cross-section relative to the xy plane.

3. Magnetic resonance probe head (40) according to claim 2, **characterized in that** the test sample (35) has a maximum diameter of 3 mm or less in the xy plane.

4. Magnetic resonance probe head (40) according to claim 2 or 3, **characterized in that** the diameter of the test sample (35) in the y direction is equal to the diameter (AUy) of the recess (34; 112; 122) in the y direction.

5. Magnetic resonance probe head (40) according to any one of the preceding claims, **characterized in that** two RF resonator coils (31, 32; 51-54) are provided which are each designed as a planar coil in a xz plane, and the two RF resonator coils (31, 32; 51-54) are separated from each other in the y direction and are disposed opposite to each other.

6. Magnetic resonance probe head (40) according to claim 5, **characterized in that** the central tube block (33; 81; 111; 121; 171; 181) comprises two flat outer surfaces that face the two RF resonator coils (31, 32; 51-54) and are each disposed in a xz plane.

7. Magnetic resonance probe head (40) according to any one of the preceding claims, **characterized in that** the entirety of the RF resonator coils (31, 32; 51-54, 61-64) is disposed mirror-symmetrically relative to a yz plane.

8. Magnetic resonance probe head (40) according to any one of the preceding claims, **characterized in that** four planar RF resonator coils (61-64) are provided, having a cross-sectional shape relative to the xy plane of two "V"s with the open sides facing each other.

9. Magnetic resonance probe head (40) according to any one of the preceding claims, **characterized in that** the central tube block (81; 111) in the xy plane has a rounded outer cross-section towards the vacuum container (43), in particular, wherein the outer cross-section is completely or sectionally elliptical or oval.

10. Magnetic resonance probe head (40) according to any one of the preceding claims, **characterized in that** the central tube block (33; 81; 111; 121; 171; 181) consists of a material having a heat conductivity ≥ 5 W/(m*K), in particular, sapphire, amorphous aluminum oxide, aluminum nitride, boron nitride, beryllium oxide, magnesium oxide or materials containing these substances, in particular machinable ceramic materials, such as Shapal.

11. Magnetic resonance probe head (40) according to any one of the preceding claims, **characterized in that** the central tube block (33; 81; 111; 121; 171; 181) has two half shells (91, 92) comprising grooves and being mounted, in particular, glued, melted or soldered to each other in a xz plane.

12. Magnetic resonance probe head (40) according to any one of the preceding claims, **characterized in that** the central tube block (33; 81; 111; 121; 171; 181) has an electrically conducting coating.

13. Magnetic resonance probe head (40) according to any one of the preceding claims, **characterized in that** the central tube block (33; 81; 111; 121; 171; 181) is surrounded by electrically non-conducting fibers.

14. Magnetic resonance probe head (40) according to any one of the preceding claims, **characterized in that** at least one coolant guidance (47, 48; 134, 135) is provided in the central tube block (33; 81; 111; 121; 181),
a test sample (35) is provided in the recess (34; 112; 122) for a test sample (35),
the at least one coolant guidance (47, 48; 134, 135) extends in the area between the RF resonator coils (31, 32; 51-54; 61-64) on the side of the test sample (35) relative to the x direction,
and the at least one coolant guidance (47, 48; 134, 135) is located in the y direction completely within the area of the y extension of the test sample (35) in the area between the RF resonator coils (31, 32; 51-54; 61-64).

15. Magnetic resonance probe head (40) according to claim 14, **characterized in that** the at least one coolant guidance (47, 48; 134, 135) has two guiding sections (38a-38f) in the area between the RF resonator coils (31, 32; 51-54; 61-64), which extend on both sides of the test sample (35) relative to the x direction.

16. Magnetic resonance probe head (40) according to claim 14 or 15, **characterized in that** the at least one coolant guidance (47, 48; 134, 135) comprises a plurality of successive guiding sections (38a-38f), in particular at least four successive guiding sections, between which the direction of extension of the coolant guidance (47, 48, 134, 135) changes in each case.

17. Magnetic resonance probe head (40) according to any one of the claims 14 to 16, **characterized in that** the at least one coolant guidance (47, 48) is separate from the recess (34) for the test sample (35).

18. Magnetic resonance probe head (40) according to claim 17, **characterized in that** the recess (34) for the test sample (35) is designed as a flow cell (182), in particular, wherein the recess (34) is directly filled with a flowable sample substance as test sample (35).

19. Magnetic resonance probe head (40) according to claim 18, **characterized in that** the flow cell (182) is designed as a spheroid with an axis of rotation extending parallel to the z direction.

20. Magnetic resonance probe head (40) according to any one of the claims 18 or 19, **characterized in that** the flow cell (182) narrows towards its feed lines (183, 184).

21. Magnetic resonance probe head (40) according to claim 17, **characterized in that** a test sample (35) is provided in the recess (34) for a test sample (35), and the test sample (35) comprises a sample container (36) which is filled with a sample substance.

22. Magnetic resonance probe head (40) according to claim 21, **characterized in that** either sections of the sample container (36) or the whole sample container (36) abut flat on the wall of the recess (34) of the central tube block (33; 81; 171) at least in the area between the RF resonator coils (31, 32; 51-54; 61-64).

23. Magnetic resonance probe head (40) according to any one of the claims 21 or 22, **characterized in that** the recess (34) is designed as a continuous bore through the central tube block (33; 81; 171), one end of the bore being closed by a stopper (161), wherein the end of the stopper (161) facing the sample container (36) is curved parallel to the end of the sample container (36) facing the stopper (161), and the magnetic susceptibility of the material of the stopper (161) corresponds to the magnetic susceptibility of the test sample (35).

24. Magnetic resonance probe head (40) according to any one of the claims 21 or 22, **characterized in that** the recess (34) is designed as a blind hole in the central tube block (33; 81; 171).

25. Magnetic resonance probe head (40) according to any one of the claims 14 to 16, **characterized in that**
the recess (112; 122) for the test sample (35; 132) also comprises the at least one coolant guidance (134, 135),
a test sample (35) is disposed in the recess (112, 122) for a test sample (35),
the test sample (35) comprises a sample container (132) containing a sample substance,
and the sample container (132) partially delimits the at least one coolant guidance (134, 135).

26. Magnetic resonance probe head (40) according to claim 25, **characterized in that** centering elements and/or stop elements (133; 141) are provided in the recess, which position the sample container (132) in the xy plane and/or in the z direction during insertion into the recess (112, 122).

27. Magnetic resonance probe head (40) according to claim 26, **characterized in that** the centering elements and/or stop elements (133; 141) are produced from a material having a magnetic susceptibility that corresponds to the volume susceptibility of a coolant of the coolant guidance (134, 135), in particular, wherein air with a volume susceptibility of 0.4 ppm in SI units or nitrogen with a volume susceptibility of -0.0064 ppm in SI units is provided in the coolant guidance (134, 135).

28. Magnetic resonance probe head (40) according to any one of the claims 25 to 27, **characterized in that** the central tube block (111) has a constant cross-sectional wall thickness relative to the xy plane at least in the area of the RF field of the RF resonator coils (31; 51-54; 61-64).

29. Magnetic resonance probe head (40) according to any one of the claims 21 to 28, **characterized in that** the recess (34; 112; 122) for the test sample (35; 132) is designed substantially cylindrical, with the cylinder axis extending in the z direction.

30. NMR (nuclear magnetic resonance) measuring apparatus, comprising a magnet system for generating a homogeneous static magnetic field B₀ in the z direction, and an NMR spectrometer comprising a magnetic resonance probe head (40) in accordance with any one of the preceding claims.

## Revendications

1. Tête de mesure à résonance magnétique (40), comprenant
- un récipient sous vide (43) dans lequel sont disposées plusieurs bobines de résonateur HF (31, 32 ; 51-54, 61-64) pouvant être refroidies à une température cryogénique,
toutes les bobines de résonateur HF (31, 32 ; 51-54, 61-64) présentant une plus grande extension dans une direction x (RSx) que dans une direction y (RSy),
toutes les bobines de résonateur HF (31, 32 ; 51-54, 61-64) étant disposées symétriquement par rapport à un plan xz, et
les directions x, y, z formant un système de coordonnées orthogonal, **caractérisée en ce que** la tête de mesure
comprend un bloc de tube central (33 ; 81 ; 111 ; 121 ; 171 ; 181) disposé entre les bobines de résonateur HF (31, 32 ; 51-54, 61-64), qui présente un évidement (34 ; 112 ; 122) allongé dans la direction z pour un échantillon de mesure (35), toutes les bobines de résonateur HF (31, 32 ; 51-54, 61-64) étant disposées symétriquement autour de l'évidement (34 ; 112 ; 122) pour l'échantillon de mesure (35),
le bloc de tube central (33 ; 81 ; 111 ; 121 ; 171 ; 181) limitant partiellement le récipient sous vide (43) et formant la paroi du récipient sous vide (43) tournée vers l'évidement (34 ; 112 ; 122), l'évidement (34 ; 112 ; 122) étant situé à l'extérieur du récipient sous vide (43),
le bloc de tube central (33 ; 81 ; 111 ; 121 ; 171 ; 181) étant conçu pour une régulation de température de l'échantillon de mesure (35) et présentant dans la zone comprise entre les bobines de résonateur HF (31, 32 ; 51-54, 61-64) une plus grande extension dans la direction x (ZRx) que dans la direction y (ZRy), et
chacune des bobines de résonateur HF étant disposée sur un substrat plan et réalisée sous la forme d'une bobine planaire qui s'étend parallèlement à la direction z.

2. Tête de mesure à résonance magnétique (40) selon la revendication 1, **caractérisée en ce qu'**un échantillon de mesure (35) est disposé dans l'évidement (34 ; 112 ; 122) pour un échantillon de mesure (35), l'échantillon de mesure (35) ayant en particulier une section transversale circulaire par rapport au plan xy.

3. Tête de mesure à résonance magnétique (40) selon la revendication 2, **caractérisée en ce que** l'échantillon de mesure (35) présente un diamètre maximal de 3 mm ou moins dans le plan xy.

4. Tête de mesure à résonance magnétique (40) selon la revendication 2 ou 3, **caractérisée en ce que** le diamètre de l'échantillon de mesure (35) dans la direction y est égal au diamètre (AUy) de l'évidement (34 ; 112 ; 122) dans la direction y.

5. Tête de mesure à résonance magnétique (40) selon une des revendications précédentes, **caractérisée en ce**
**que** deux bobines de résonateurs HF (31, 32 ; 51-54) sont prévues, qui sont réalisées chacune sous la forme de bobines planaires dans un plan xz,
et **que** les deux bobines de résonateurs HF (31, 32 ; 51-54) sont espacées dans la direction y et situées l'une en face de l'autre.

6. Tête de mesure à résonance magnétique (40) selon la revendication 5, **caractérisée en ce que** le bloc de tube central (33 ; 81 ; 111 ; 121 ; 171 ; 181) présente deux surfaces extérieures planes tournées vers les deux bobines de résonateurs HF (31, 32 ; 51-54), qui se situent chacune dans un plan xz.

7. Tête de mesure à résonance magnétique (40) selon une des revendications précédentes, **caractérisée en ce que** toutes les bobines de résonateurs HF (31, 32 ; 51-54, 61-64) sont disposées symétriquement par rapport à un plan yz.

8. Tête de mesure à résonance magnétique (40) selon une des revendications précédentes, **caractérisée en ce que** quatre bobines de résonateurs HF planaires (61-64) sont prévues, qui présentent, en section transversale par rapport au plan xy, la forme de deux « V » dirigés l'un vers l'autre par leurs côtés ouverts.

9. Tête de mesure à résonance magnétique (40) selon une des revendications précédentes, **caractérisée en ce que** le bloc de tube central (81 ; 111) présente dans le plan xy une section transversale extérieure arrondie vers le récipient sous vide (43),
la section transversale extérieure étant en particulier en totalité ou en partie elliptique ou ovale.

10. Tête de mesure à résonance magnétique (40) selon une des revendications précédentes, **caractérisée en ce que** le bloc de tube central (33 ; 81 ; 111 ; 121 ; 171 ; 181) est composé d'un matériau ayant une conductibilité thermique ≥ 5 W/(m*K), en particulier de saphir, oxyde d'aluminium amorphe, nitrure d'aluminium, nitrure de bore, oxyde de béryllium, oxyde de magnésium ou de matériaux qui contiennent ces matériaux, en particulier de céramiques usinables par enlèvement de copeaux comme le Shapal.

11. Tête de mesure à résonance magnétique (40) selon une des revendications précédentes, **caractérisée en ce que** le bloc de tube central (33 ; 81 ; 111 ; 121 ; 171 ; 181) présente deux demi-coques (91, 92) pourvues de rainures qui sont fixées l'une à l'autre dans un plan xz, en particulier collées, liées par fusion ou brasées ensemble.

12. Tête de mesure à résonance magnétique (40) selon une des revendications précédentes, **caractérisée en ce que** le bloc de tube central (33 ; 81 ; 111 ; 121 ; 171 ; 181) présente un revêtement électriquement conducteur.

13. Tête de mesure à résonance magnétique (40) selon une des revendications précédentes, **caractérisée en ce que** le bloc de tube central (33 ; 81 ; 111 ; 121 ; 171 ; 181) est entouré de fibres électriquement non conductrices.

14. Tête de mesure à résonance magnétique (40) selon une des revendications précédentes, **caractérisée en ce qu'**au moins un guide de liquide de refroidissement (47, 48 ; 134, 135) est prévu dans le bloc de tube central (33 ; 81 ; 111 ; 121 ; 181), qu'un échantillon de mesure (35) est disposé dans l'évidement (34 ; 112 ; 122) pour un échantillon de mesure (35),
que dans la zone comprise entre les bobines de résonateurs HF (31, 32 ; 51-54 ; 61-64), ledit au moins un guide de liquide de refroidissement (47, 48 ; 134, 135) s'étend à côté de l'échantillon de mesure (35) par rapport à la direction x,
et que dans la zone comprise entre les bobines de résonateurs HF (31, 32 ; 51-54 ; 61-64) ledit au moins un guide de liquide de refroidissement (47, 48 ; 134, 135) se trouve, dans la direction y, entièrement à l'intérieur de la zone de l'extension y de l'échantillon de mesure (35).

15. Tête de mesure à résonance magnétique (40) selon la revendication 14, **caractérisée en ce que** ledit au moins un guide de liquide de refroidissement (47, 48 ; 134, 135) présente dans la zone comprise entre les bobines de résonateurs HF (31, 32 ; 51-54 ; 61-64) deux portions de guidage (38a-38f) qui s'étendent des deux côtés de l'échantillon de mesure (35) par rapport à la direction x.

16. Tête de mesure à résonance magnétique (40) selon la revendication 14 ou 15, **caractérisée en ce que** ledit au moins un guide de liquide de refroidissement (47, 48 ; 134, 135) présente une pluralité de portions de guidage successives (38a-38f), en particulier au moins quatre portions de guidage successives, entre lesquelles la direction d'extension du guide de liquide de refroidissement (47, 48, 134, 135) change à chaque fois.

17. Tête de mesure à résonance magnétique (40) selon une des revendications 14 à 16, **caractérisée en ce que** ledit au moins un guide de liquide de refroidissement (47, 48) est séparé de l'évidement (34) pour l'échantillon de mesure (35).

18. Tête de mesure à résonance magnétique (40) selon la revendication 17, **caractérisée en ce**
**que** l'évidement (34) pour l'échantillon de mesure (35) est réalisé sous la forme d'une cellule à circulation (182),
l'évidement (34) étant en particulier directement rempli d'une substance échantillon fluide comme échantillon de mesure (35).

19. Tête de mesure à résonance magnétique (40) selon la revendication 18, **caractérisée en ce que** la cellule à circulation (182) est réalisée sous la forme d'un ellipsoïde de révolution avec un axe de rotation parallèle à la direction z.

20. Tête de mesure à résonance magnétique (40) selon une des revendications 18 ou 19, **caractérisée en ce que** la cellule à circulation (182) se rétrécit en direction de ses amenées (183, 184).

21. Tête de mesure à résonance magnétique (40) selon la revendication 17, **caractérisée en ce qu'**un échantillon de mesure (35) est disposé dans l'évidement (34) pour un échantillon de mesure (35),
et que l'échantillon de mesure (35) comprend un récipient à échantillon (36) qui est rempli d'une substance échantillon.

22. Tête de mesure à résonance magnétique (40) selon la revendication 21, **caractérisée en ce que** le récipient à échantillon (36) est appliqué en partie ou en totalité à plat sur la paroi de l'évidement (34) du bloc de tube central (33 ; 81 ; 171), au moins dans la zone comprise entre les bobines de résonateurs HF (31, 32 ; 51-54 ; 61-64).

23. Tête de mesure à résonance magnétique (40) selon une des revendications 21 ou 22, **caractérisée en ce**
**que** l'évidement (34) est réalisé sous la forme d'un perçage continu à travers le bloc de tube central (33 ; 81 ; 171),
**que** le perçage est fermé par un bouchon (161) à une extrémité,
l'extrémité du bouchon (161) tournée vers le récipient à échantillon (36) étant courbée parallèlement à l'extrémité du récipient à échantillon (36) tournée vers le bouchon (161),
et **que** la susceptibilité magnétique du matériau du bouchon (161) correspond à la susceptibilité magnétique de l'échantillon de mesure (35).

24. Tête de mesure à résonance magnétique (40) selon une des revendications 21 ou 22, **caractérisée en ce que** l'évidement (34) est réalisé sous la forme d'un trou borgne dans le bloc de tube central (33 ; 81 ; 171).

25. Tête de mesure à résonance magnétique (40) selon une des revendications 14 à 16, **caractérisée en ce**
**que** l'évidement (112 ; 122) pour l'échantillon de mesure (35 ; 132) comprend aussi ledit au moins un guide de liquide de refroidissement (134, 135),
**qu'**un échantillon de mesure (35) est disposé dans l'évidement (112, 122) pour un échantillon de mesure (35),
**que** l'échantillon de mesure (35) comprend un récipient à échantillon (132) qui contient une substance échantillon,
et **que** le récipient à échantillon (132) limite partiellement ledit au moins un guide de liquide de refroidissement (134, 135).

26. Tête de mesure à résonance magnétique (40) selon la revendication 25, **caractérisée en ce que** des éléments de centrage et/ou des éléments de butée (133 ; 141) sont prévus dans l'évidement, qui positionnent le récipient à échantillon (132) dans le plan xy et/ou dans la direction z lors de son introduction dans l'évidement (112, 122).

27. Tête de mesure à résonance magnétique (40) selon la revendication 26, **caractérisée en ce que** les éléments de centrage et/ou les éléments de butée (133 ; 141) sont fabriqués dans un matériau ayant une susceptibilité magnétique qui correspond à la susceptibilité volumique d'un liquide de refroidissement du guide de liquide de refroidissement (134, 135),
de l'air d'une susceptibilité volumique de 0,4 ppm en unités SI ou de l'azote d'une susceptibilité volumique de -0,0064 ppm en unités SI étant en particulier prévu dans le guide de liquide de refroidissement (134, 135).

28. Tête de mesure à résonance magnétique (40) selon une des revendications 25 à 27, **caractérisée en ce que** le bloc de tube central (111) présente, au moins dans la zone du champ HF des bobines de résonateurs HF (31 ; 51-54 ; 61-64), une épaisseur de paroi constante en section transversale par rapport au plan xy.

29. Tête de mesure à résonance magnétique (40) selon une des revendications 21 à 28, **caractérisée en ce que** l'évidement (34 ; 112 ; 122) pour l'échantillon de mesure (35 ; 132) présente une forme sensiblement cylindrique avec l'axe du cylindre dans la direction z.

30. Appareil de mesure de RMN (résonance magnétique nucléaire), comprenant un système magnétique pour générer un champ magnétique statique homogène B₀ dans la direction z et un spectromètre de RMN doté d'une tête de mesure à résonance magnétique (40) selon une des revendications précédentes.
